# EUROPEAN PATENT APPLICATION

(11) **EP 4 672 304 A1**
(43) Date of publication of application: **31.12.2025**
(21) Application number: 24760308.7
(22) Date of filing: 19.02.2024
(51) Int. Cl.: H01L 21/304

(54) **SUBSTRATE TREATMENT DEVICE AND SUBSTRATE TREATMENT METHOD**

(30) Priority: 24.02.2023 JP 2023026837
(71) Applicant: SCREEN Holdings Co., Ltd., Kyoto-shi, Kyoto 602-8585 (JP)
(72) Inventor: OZAKI, Koh, Kyoto-shi, Kyoto 602-8585 (JP); URATA, Shingo, Kyoto-shi, Kyoto 602-8585 (JP); TAKEDA, Daisuke, Kyoto-shi, Kyoto 602-8585 (JP)
(74) Representative: Kilian Kilian & Partner mbB
(86) International application number: PCT/JP2024/005774
(87) International publication number: WO 2024/177009

(57) **Abstract**

A substrate processing apparatus (100) includes a nozzle (3), a substrate holding portion (2), a liquid receiving portion (11), a drainage mechanism (6), and a nozzle moving portion (5). The nozzle (3) selectively discharges a plurality of types of processing liquids including an acid chemical liquid, an alkaline chemical liquid, and a rinse liquid. The substrate holding portion (2) holds a substrate (W). The liquid receiving portion (11) is located outside the substrate holding portion (2) and receives the processing liquid discharged from the nozzle (3). The drainage mechanism (6) guides the acid chemical liquid discharged from the liquid receiving portion (11) to a first drainage piping (DP1) and guides the alkaline chemical liquid discharged from the liquid receiving portion (11) to a second drainage piping (DP2). The nozzle moving portion (5) moves the nozzle (3) between a processing position (PS1) opposing the substrate (W) held by the substrate holding portion (2) and a standby position (PS2) opposing the liquid receiving portion (11).

## Description

### Technical Field

The present invention relates to a substrate processing apparatus and a substrate processing method.

### Background Art

A single substrate processing type substrate processing apparatus that discharges a chemical liquid and a rinse liquid toward a rotating substrate to process the substrate is known. This type of substrate processing apparatus processes substrates one by one with the chemical liquid and the rinse liquid. For example, Patent Literature 1 discloses a single substrate processing type substrate processing apparatus.

The substrate processing apparatus of Patent Literature 1 includes a first scan nozzle that discharges a first chemical liquid, a second scan nozzle that discharges a second chemical liquid, and a fixed nozzle that discharges a rinse liquid. After moving from a first standby position to a processing position, the first scan nozzle discharges the first chemical liquid from the processing position toward a rotating substrate. The second scan nozzle moves from a second standby position different from the first standby position to the processing position, and then discharges the second chemical liquid from the processing position toward the rotating substrate. The substrate processing apparatus of Patent Literature 1 supplies the first chemical liquid, the second chemical liquid, and the rinse liquid to the substrate in the order of the first chemical liquid, the rinse liquid, the second chemical liquid, and the rinse liquid.

### CITATION LIST

### Patent Literature

Patent Literature 1: Japanese Patent Application Publication No. 2019-057625

### Summary of Invention

### Technical Problem

However, in the substrate processing apparatus of Patent Literature 1, when switching from the first chemical liquid to the rinse liquid, the discharge of the first chemical liquid is stopped, the first scan nozzle is moved to the first standby position, and then the rinse liquid is discharged from the fixed nozzle. Also, when the rinse liquid is switched to the second chemical liquid, the discharge of the rinse liquid is stopped, and then the second scan nozzle is moved from the second standby position to the processing position to discharge the second chemical liquid. Therefore, when the first chemical liquid is switched to the rinse liquid, there is a possibility that an outer peripheral portion of the substrate is not covered with a liquid film. Similarly, when the rinse liquid is switched to the second chemical liquid, there is a possibility that the outer peripheral portion of the substrate is not covered with a liquid film. As a result, for example, in subsequent steps, pattern collapse is likely to occur at the outer peripheral portion of the substrate. Therefore, there is room for further improvement in consideration of the yield.

The present invention has been made in view of the above problems, and an object thereof is to provide a substrate processing apparatus and a substrate processing method in which an outer peripheral portion of a substrate is less likely to become uncovered with a liquid film when a processing liquid is switched.

### Solution to Problem

According to one aspect of the present invention, a substrate processing apparatus includes a nozzle, a substrate holding portion, a liquid receiving portion, a drainage mechanism, and a nozzle moving portion. The nozzle selectively discharges a plurality of types of processing liquids including an acid chemical liquid, an alkaline chemical liquid, and a rinse liquid. The substrate holding portion holds a substrate. The liquid receiving portion is located outside the substrate holding portion and receives the processing liquid discharged from the nozzle. The drainage mechanism guides the acid chemical liquid discharged from the liquid receiving portion to a first drainage piping, and guides the alkaline chemical liquid discharged from the liquid receiving portion to a second drainage piping. The nozzle moving portion moves the nozzle between a processing position opposing the substrate held by the substrate holding portion and a standby position opposing the liquid receiving portion.

In a preferred embodiment, the substrate processing apparatus further includes a controlling portion. The controlling portion controls supply of the plurality of types of processing liquids to the nozzle. When switching the type of the processing liquid to be discharged from the nozzle to the substrate, the controlling portion delays a supply stop timing of the processing liquid previously discharged from the nozzle, and simultaneously supplies the two types of processing liquids to the nozzle for a certain period of time.

In a preferred embodiment, the substrate processing apparatus further includes a storage portion, an input portion, and a controlling portion. The storage portion stores a discharge order. The discharge order indicates an order of discharging the plurality of types of processing liquids from the nozzle. The input portion is operated by a user to input the discharge order. The controlling portion prohibits setting of the discharge order to discharge the alkaline chemical liquid after discharging the acid chemical liquid.

In a preferred embodiment, the substrate processing apparatus further includes a liquid tank, a supply piping, a suck back mechanism, and a controlling portion. The alkaline chemical liquid flows into the liquid tank from the second drainage piping. The supply piping selectively supplies the plurality of types of processing liquids to the nozzle. The suck back mechanism is connected to the supply piping. The suck back mechanism sucks back the processing liquid staying between a connection point with the supply piping and a tip of the nozzle. The suck back mechanism allows the sucked processing liquid to flow to the liquid tank. The controlling portion prohibits operation of the suck back mechanism when the processing liquid finally discharged from the nozzle in a discharge order that is an order of discharging the plurality of types of processing liquids from the nozzle to the substrate is a processing liquid other than the rinse liquid.

In a preferred embodiment, the substrate processing apparatus further includes a cup portion. The cup portion receives the processing liquid discharged from the substrate. The drainage mechanism guides the acid chemical liquid discharged from the cup portion to the first drainage piping, and guides the alkaline chemical liquid discharged from the cup portion to the second drainage piping.

In a preferred embodiment, the liquid receiving portion includes a first liquid receiving portion and a second liquid receiving portion. The first liquid receiving portion receives the acid chemical liquid. The second liquid receiving portion receives the alkaline chemical liquid. The drainage mechanism guides the acid chemical liquid discharged from the first liquid receiving portion to the first drainage piping, and guides the alkaline chemical liquid discharged from the second liquid receiving portion to the second drainage piping.

In a preferred embodiment, the substrate processing apparatus further includes a storage portion and a controlling portion. The storage portion stores a discharge order. The discharge order indicates an order of discharging the plurality of types of processing liquids from the nozzle to the substrate. The controlling portion generates an order of discharging the plurality of types of processing liquids from the nozzle to the liquid receiving portion based on the discharge order.

In a preferred embodiment, the plurality of types of processing liquids further include an organic solvent. The drainage mechanism guides the acid chemical liquid discharged from the liquid receiving portion to the first drainage piping, guides the alkaline chemical liquid discharged from the liquid receiving portion to the second drainage piping, and guides the organic solvent discharged from the liquid receiving portion to a third drainage piping.

In a preferred embodiment, the substrate processing apparatus further includes a cup portion. The cup portion receives the processing liquid discharged from the substrate. The drainage mechanism guides the acid chemical liquid discharged from the cup portion to the first drainage piping, guides the alkaline chemical liquid discharged from the cup portion to the second drainage piping, and guides the organic solvent discharged from the cup portion to the third drainage piping.

In a preferred embodiment, the liquid receiving portion includes a first liquid receiving portion, a second liquid receiving portion, and a third liquid receiving portion. The first liquid receiving portion receives the acid chemical liquid. The second liquid receiving portion receives the alkaline chemical liquid. The third liquid receiving portion receives the organic solvent. The drainage mechanism guides the acid chemical liquid discharged from the first liquid receiving portion to the first drainage piping, guides the alkaline chemical liquid discharged from the second liquid receiving portion to the second drainage piping, and guides the organic solvent discharged from the third liquid receiving portion to the third drainage piping.

In another aspect of the present invention, a substrate processing method includes a step of selectively discharging a plurality of types of processing liquids including an acid chemical liquid, an alkaline chemical liquid, and a rinse liquid from a nozzle located at a position opposing a liquid receiving portion located outside a substrate holding portion holding a substrate, a step of guiding the acid chemical liquid discharged from the liquid receiving portion to a first drainage piping, a step of guiding the alkaline chemical liquid discharged from the liquid receiving portion to a second drainage piping, and a step of moving the nozzle to a position opposing the substrate to selectively discharge the plurality of types of processing liquids from the nozzle to the substrate. Advantageous Effects of Invention

According to the substrate processing apparatus and the substrate processing method of the present invention, the outer peripheral portion of the substrate is less likely to become uncovered with a liquid film when the processing liquid is switched.

### Brief Description of Drawings

[FIG. 1] is a schematic plan view of a substrate processing apparatus according to a first preferred embodiment of the present invention.
[FIG. 2] is a schematic view of an internal configuration of a substrate processing portion, a configuration of a drainage mechanism, and a configuration of a liquid supply mechanism included in the substrate processing apparatus according to the first preferred embodiment of the present invention.
[FIG. 3] is a plan view schematically illustrating the inside of the substrate processing portion included in the substrate processing apparatus according to the first preferred embodiment of the present invention.
[FIG. 4] is a view schematically illustrating the configuration of the drainage mechanism included in the substrate processing apparatus according to the first preferred embodiment of the present invention.
[FIG. 5] is a flowchart illustrating a method of pre-dispensing a processing liquid from a nozzle.
[FIG. 6] is a flowchart illustrating a method of processing a substrate.
[FIG. 7] (a) is a block diagram illustrating a part of the configuration of the substrate processing apparatus according to the first preferred embodiment of the present invention. (b) is a diagram illustrating an error message displayed on a display portion included in the substrate processing apparatus according to the first preferred embodiment of the present invention.
[FIG. 8] (a) is a diagram schematically illustrating a first example of a pre-recipe. (b) is a diagram schematically illustrating a second example of the pre-recipe.
[FIG. 9] (a) is a diagram schematically illustrating a first example of a process recipe. (b) is a diagram schematically illustrating a second example of the process recipe.
[FIG. 10] is a diagram illustrating a timing of supplying the processing liquid to the nozzle.
[FIG. 11] is a view schematically illustrating an internal configuration of a substrate processing portion, a configuration of a drainage mechanism, and a configuration of a liquid supply mechanism included in a substrate processing apparatus according to a second preferred embodiment of the present invention.
[FIG. 12] is a view schematically illustrating the configuration of the drainage mechanism included in the substrate processing apparatus according to the second preferred embodiment of the present invention.
[FIG. 13] is a view schematically illustrating an internal configuration of a substrate processing portion, a configuration of a drainage mechanism, and a configuration of a liquid supply mechanism included in a substrate processing apparatus according to a third preferred embodiment of the present invention.
[FIG. 14] is a view schematically illustrating the configuration of the drainage mechanism included in the substrate processing apparatus according to the third preferred embodiment of the present invention.
[FIG. 15] is a flowchart illustrating a method of pre-dispensing a processing liquid from a nozzle.
[FIG. 16] is a flowchart illustrating a method of processing a substrate.
[FIG. 17] is a view schematically illustrating an internal configuration of a substrate processing portion, a configuration of a drainage mechanism, and a configuration of a liquid supply mechanism included in a substrate processing apparatus according to a fourth preferred embodiment of the present invention.
[FIG. 18] is a view schematically illustrating the configuration of the drainage mechanism included in the substrate processing apparatus according to the fourth preferred embodiment of the present invention.

### Description of Embodiments

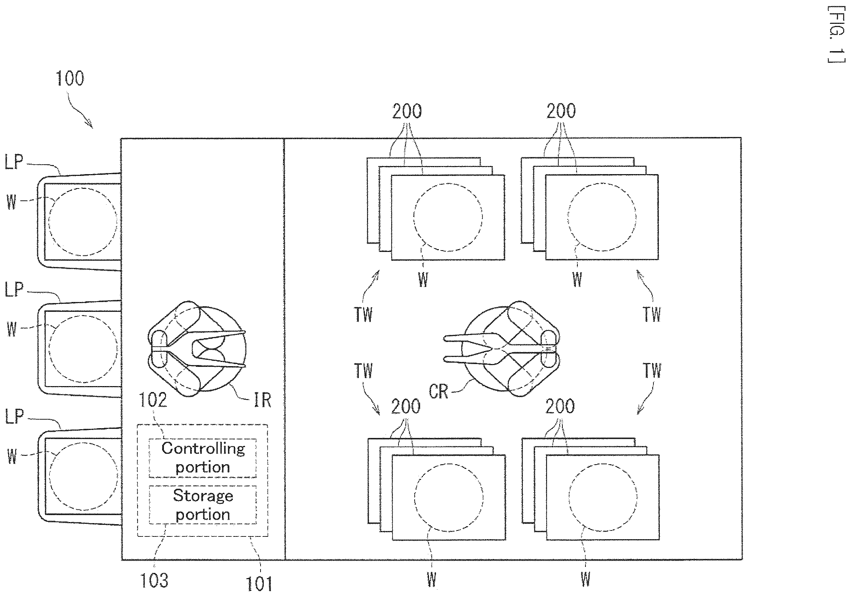

Hereinafter, preferred embodiments according to a substrate processing apparatus and a substrate processing method of the present invention will be described with reference to the drawings (FIGS. 1 to 18). However, the present invention is not restricted to the preferred embodiments described below and can be implemented in various modes within a scope not deviating from its gist. It is noted that, for portions for which description is redundant, the description is at times omitted as appropriate. Also, in the figures, same or corresponding portions are provided with the same reference sign and description shall not be repeated.

Various substrates such as a semiconductor wafer, a glass substrate for a photomask, a glass substrate for a liquid crystal display, a glass substrate for a plasma display, a substrate for a field emission display (FED), a substrate for an optical disk, a substrate for a magnetic disk, and a substrate for a magneto-optical disk can be applied to a "substrate" to be subjected to substrate processing in the substrate processing apparatus and the substrate processing method according to the present invention. Hereinafter, preferred embodiments of the present invention will be mainly described by taking an example of a case where a disk-shaped semiconductor wafer is to be subjected to substrate processing, but the substrate processing apparatus and the substrate processing method according to the present invention can be similarly applied to various substrates other than the semiconductor wafer described above. Also, the shape of the substrate is not limited to the disk shape, and the substrate processing apparatus and the substrate processing method according to the present invention can be applied to substrates having various shapes.

### [First Preferred Embodiment]

First, a first preferred embodiment of the present invention will be described with reference to FIGS. 1 to 10. FIG. 1 is a schematic plan view of a substrate processing apparatus 100 according to the present preferred embodiment. The substrate processing apparatus 100 processes a substrate W. More specifically, the substrate processing apparatus 100 is a single substrate processing type apparatus, and processes the substrates W one by one using a plurality of types of processing liquids.

As illustrated in FIG. 1, the substrate processing apparatus 100 includes a plurality of substrate processing portions 200, a plurality of load ports LP, an indexer robot IR, a center robot CR, and a controller 101.

Each of the load ports LP stacks and accommodates a plurality of substrates W. The indexer robot IR transfers the substrate W between the load port LP and the center robot CR. The center robot CR transfers the substrate W between the indexer robot IR and the substrate processing portion 200. Furthermore, as a device configuration, a placing table (path) on which the substrate W is temporarily placed may be provided between the indexer robot IR and the center robot CR, and the substrate W may be indirectly transferred between the indexer robot IR and the center robot CR through the placing table.

The plurality of substrate processing portions 200 form a plurality of towers TW (four towers TW in FIG. 1). The plurality of towers TW are located so as to surround the center robot CR in plan view. Each tower TW includes a plurality of substrate processing portions 200 (three substrate processing portions 200 in FIG. 1) stacked vertically.

Each of the substrate processing portions 200 sequentially supplies a plurality of types of processing liquids to an upper surface of the substrate W. As a result, the substrate W is processed. In the present preferred embodiment, the substrate processing portion 200 performs an etching processing. Specifically, the substrate processing portion 200 etches a hard mask formed on the substrate W.

The plurality of types of processing liquids include an acid chemical liquid, an alkaline chemical liquid, and a rinse liquid. The acid chemical liquid is, for example, DHF (dilute hydrofluoric acid). The alkaline chemical liquid is, for example, SC1 (a mixed liquid of ammonia and hydrogen peroxide water). SC1 is a mixed liquid of ammonia water (NH₄OH), hydrogen peroxide water (H₂O₂), and water such as pure water. The pure water is, for example, deionized water (DIW). The rinse liquid is, for example, water such as pure water (for example, deionized water). Each of the substrate processing portions 200 supplies an acid chemical liquid (for example, DHF), an alkaline chemical liquid (for example, SC1), and a rinse liquid (for example, DIW) to the substrate W in the order of the acid chemical liquid, the rinse liquid, the alkaline chemical liquid, and the rinse liquid to process the substrate W.

The controller 101 controls the operation of each portion of the substrate processing apparatus 100. For example, the controller 101 controls the load port LP, the indexer robot IR, the center robot CR, and the substrate processing portion 200. The controller 101 includes a controlling portion 102 and a storage portion 103.

The controlling portion 102 controls the operation of each portion of the substrate processing apparatus 100 on the basis of various types of information stored in the storage portion 103. The controlling portion 102 includes, for example, a processor. The controlling portion 102 may include a central processing unit (CPU) or a micro processing unit (MPU) as a processor. Alternatively, the controlling portion 102 may include a general-purpose computing unit or a specialized computing unit.

The storage portion 103 stores various types of information for controlling the operation of the substrate processing apparatus 100. For example, the storage portion 103 stores data and a computer program. The data includes various recipe data. The recipe data includes a process recipe SRP and a pre-recipe YRP. The process recipe SRP is data defining substrate processing procedures. Specifically, the process recipe SRP defines an execution order of a series of processes included in the substrate processing, a content of each process, and a condition (parameter setting value) of each process. The pre-recipe YRP defines an order of the processing liquid to be discharged from a nozzle 3 at the time of the pre-dispensing process.

The storage portion 103 includes a main storage device. The main storage device is, for example, a semiconductor memory. The storage portion 103 may further include an auxiliary storage device. The auxiliary storage device includes, for example, at least one of a semiconductor memory and a hard disk drive. The storage portion 103 may include a removable medium.

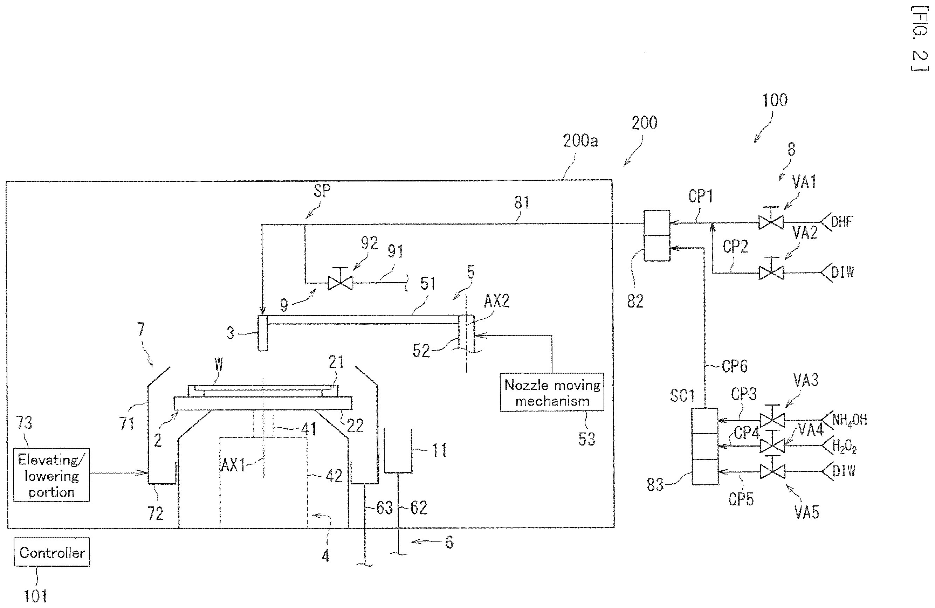

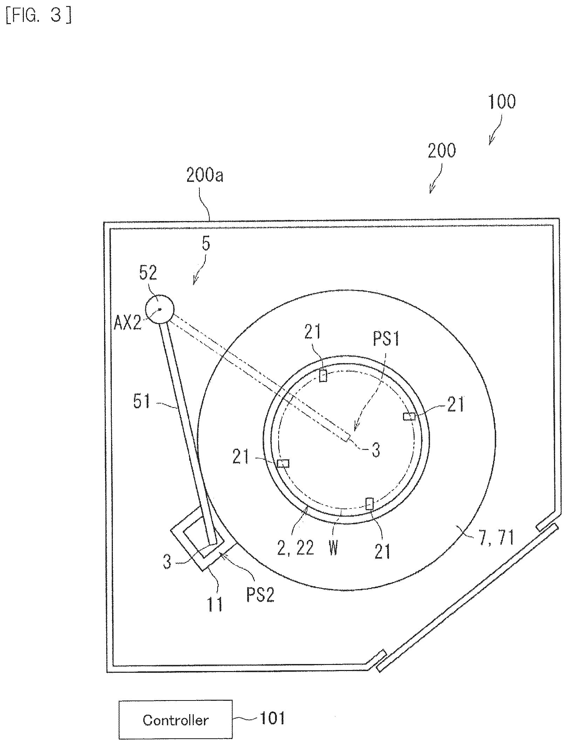

Next, the substrate processing apparatus 100 according to the present preferred embodiment will be described with reference to FIGS. 1 to 3. FIG. 2 is a view schematically illustrating an internal configuration of the substrate processing portion 200, a configuration of a drainage mechanism 6, and a configuration of a liquid supply mechanism 8 included in the substrate processing apparatus 100 according to the present preferred embodiment. FIG. 3 is a plan view schematically illustrating the inside of the substrate processing portion 200 included in the substrate processing apparatus 100 according to the present preferred embodiment.

As illustrated in FIGS. 2 and 3, the substrate processing portion 200 includes a processing chamber 200a, a substrate holding portion 2, a nozzle 3, a substrate rotating portion 4, a nozzle moving portion 5, a cup portion 7, a suck back mechanism 9, a liquid receiving portion 11, and an elevating/lowering portion 73. Also, the substrate processing apparatus 100 further includes a drainage mechanism 6 and a liquid supply mechanism 8.

The substrate W is loaded into the processing chamber 200a and processed in the processing chamber 200a. The processing chamber 200a has a substantially box shape. The processing chamber 200a accommodates the substrate holding portion 2, the nozzle 3, the substrate rotating portion 4, the nozzle moving portion 5, a part of the drainage mechanism 6, the cup portion 7, a part of the liquid supply mechanism 8, a part of the suck back mechanism 9, the liquid receiving portion 11, and the elevating/lowering portion 73. The processing chamber 200a is, for example, a chamber.

The substrate holding portion 2 holds the substrate W. The operation of the substrate holding portion 2 is controlled by the controller 101 (controlling portion 102). More specifically, the substrate holding portion 2 holds the substrate W in a horizontal posture. The substrate holding portion 2 is, for example, a spin chuck. In the present preferred embodiment, the substrate holding portion 2 includes a plurality of chuck members 21 and a spin base 22.

As illustrated in FIG. 3, the spin base 22 has a substantially disk shape and supports the plurality of chuck members 21 in a horizontal posture. The plurality of chuck members 21 are located in a peripheral edge portion of the spin base 22. The plurality of chuck members 21 grip a peripheral edge portion of the substrate W. The substrate W is held in a horizontal posture by the plurality of chuck members 21. The operation of the plurality of chuck members 21 is controlled by the controller 101 (controlling portion 102). The plurality of chuck members 21 are located such that the center of the substrate W coincides with the center of the spin base 22.

As illustrated in FIG. 2, the substrate rotating portion 4 rotates the substrate holding portion 2 to rotate the substrate W held by the substrate holding portion 2. Specifically, the substrate rotating portion 4 integrally rotates the substrate W and the substrate holding portion 2 about a first rotation axis AX1 extending in the vertical direction. The operation of the substrate rotating portion 4 is controlled by the controller 101 (controlling portion 102).

Specifically, the first rotation axis AX1 passes through the center of the spin base 22. Therefore, the spin base 22 rotates about the center of the spin base 22 as a rotation center. Also, as described above, the substrate holding portion 2 holds the substrate W so that the center of the substrate W coincides with the center of the spin base 22. Therefore, the substrate W rotates about the center of the substrate W as the rotation center.

The substrate rotating portion 4 includes, for example, a shaft 41 and a motor body 42. The shaft 41 is coupled to the spin base 22. The motor body 42 rotates the shaft 41. As a result, the spin base 22 rotates. The operation of the motor body 42 is controlled by the controller 101 (controlling portion 102). The motor body 42 is, for example, an electric motor.

As illustrated in FIG. 3, the nozzle moving portion 5 is controlled by the controller 101 (controlling portion 102) to move the nozzle 3 between a processing position PS1 and a standby position PS2. The processing position PS1 is a position opposing the substrate W held by the substrate holding portion 2. The standby position PS2 is a position outside the substrate holding portion 2 in plan view. In the present preferred embodiment, the standby position PS2 is a position outside the cup portion 7 in plan view. More specifically, the standby position PS2 is a position opposing the liquid receiving portion 11.

Specifically, the nozzle moving portion 5 moves the nozzle 3 in the vertical direction and the horizontal direction. Specifically, as illustrated in FIG. 2, the nozzle moving portion 5 includes an arm 51, a base 52, and a nozzle moving mechanism 53.

The arm 51 extends along the horizontal direction. The arm 51 supports the nozzle 3. For example, the nozzle 3 is coupled to the tip portion of the arm 51. The arm 51 is coupled to the base 52. The base 52 extends along the vertical direction.

The nozzle moving mechanism 53 moves the arm 51 in the vertical direction and the horizontal direction. As a result, the nozzle 3 moves in the vertical direction and the horizontal direction. The nozzle moving mechanism 53 is controlled by the controller 101 (controlling portion 102).

Specifically, the nozzle moving mechanism 53 swings the base 52 about a second rotation axis AX2 extending in the vertical direction to swing the arm 51 along a horizontal plane. As a result, the nozzle 3 moves along the horizontal plane. Also, the nozzle moving mechanism 53 elevates and lowers the base 52 along the vertical direction to elevate and lower the arm 51. As a result, the nozzle 3 moves along the vertical direction. The nozzle moving mechanism 53 includes, for example, a ball screw mechanism and an electric motor capable of rotating forward and backward. The electric motor drives the ball screw mechanism.

At the time of the substrate processing, the nozzle 3 selectively discharges a plurality of types of processing liquids from the processing position PS1 (see FIG. 3) toward the upper surface of the substrate W held by the substrate holding portion **2.** The processing liquid is discharged from the tip of the nozzle **3.** More specifically, the nozzle 3 selectively discharges an acid chemical liquid, an alkaline chemical liquid, and a rinse liquid from the processing position PS1 (see FIG. 3) toward the upper surface of the substrate W rotated by the substrate rotating portion 4.

In the present preferred embodiment, the nozzle 3 discharges the acid chemical liquid, the alkaline chemical liquid, and the rinse liquid in the order of the acid chemical liquid, the rinse liquid, the alkaline chemical liquid, and the rinse liquid at the time of the substrate processing. A first discharge order, which is an order of discharging a plurality of types of processing liquids from the nozzle 3 at the time of the substrate processing, is stored in the storage portion 103 (see FIG. 1). Specifically, the first discharge order is defined by the process recipe SRP.

Further, the nozzle 3 performs a pre-dispensing process. The pre-dispensing process is performed while the nozzle 3 is located at the standby position PS2 (see FIG. 3). Specifically, the pre-dispensing process indicates a process of discharging a processing liquid from the nozzle 3 toward the liquid receiving portion 11 before the substrate processing is performed. At the time of performing the pre-dispensing process, the nozzle 3 selectively discharges a plurality of types of processing liquids.

In the present preferred embodiment, the nozzle 3 discharges the acid chemical liquid, the alkaline chemical liquid, and the rinse liquid in the order of the acid chemical liquid, the rinse liquid, the alkaline chemical liquid, and the rinse liquid at the time of performing the pre-dispensing process. A second discharge order, which is an order of discharging a plurality of types of processing liquids from the nozzle 3 toward the liquid receiving portion 11 at the time of the pre-dispensing process, is stored in the storage portion 103 (see FIG. 1). Specifically, the second discharge order is defined by the pre-recipe YRP.

The cup portion 7 receives the processing liquid discharged from the substrate W and prevents the processing liquid from scattering into the processing chamber 200a. Specifically, the cup portion 7 includes a guard portion 71 and a cup liquid receiving portion 72.

The guard portion 71 is located outside the substrate holding portion 2 and the substrate rotating portion 4. The guard portion 71 has a substantially cylindrical shape. In other words, the guard portion 71 surrounds the substrate holding portion 2 and the substrate rotating portion 4. The guard portion 71 receives the processing liquid scattered from the rotating substrate W.

The cup liquid receiving portion 72 is coupled to a lower end portion of the guard portion 71. The cup liquid receiving portion 72 has an annular shape, and forms an annular groove inside the guard portion 71. The processing liquid received by the guard portion 71 flows down to the cup liquid receiving portion 72 by its own weight. Alternatively, the processing liquid received by the guard portion 71 splashes back from the guard portion 71 and falls into the cup liquid receiving portion 72 by its own weight. As a result, the processing liquid is collected in the groove of the cup liquid receiving portion 72.

The elevating/lowering portion 73 elevates and lowers the cup portion 7. The elevating/lowering portion 73 is controlled by the controller 101 (controlling portion 102). The elevating/lowering portion 73 includes, for example, a ball screw mechanism and an electric motor capable of rotating forward and backward. The electric motor drives the ball screw mechanism.

Specifically, the elevating/lowering portion 73 elevates and lowers the cup portion 7 between an upper position and a lower position. The upper position is a position above the lower position. For example, when the substrate W is loaded into the processing chamber 200a by the center robot CR (FIG. 1) or when the substrate W is unloaded from the processing chamber 200a by the center robot CR (FIG. 1), the cup portion 7 is retracted to the lower position. The cup portion 7 is located at the upper position when receiving the processing liquid. In other words, the cup portion 7 is located at the upper position at the time of the substrate processing.

The liquid receiving portion 11 is located outside the substrate holding portion 2. The liquid receiving portion 11 receives the processing liquid discharged from the nozzle 3 at the time of the pre-dispensing process. In the present preferred embodiment, the liquid receiving portion 11 is located outside the cup portion 7. Specifically, the liquid receiving portion 11 is located below the standby position PS2 (see FIG. 3). The liquid receiving portion 11 is, for example, a standby pod.

The drainage mechanism 6 discharges the processing liquid collected in the cup portion 7 from the cup portion 7. Also, the drainage mechanism 6 discharges the processing liquid collected in the liquid receiving portion 11 from the liquid receiving portion 11. Specifically, the drainage mechanism 6 includes a pod drainage piping 62 and a cup drainage piping 63. The processing chamber 200a accommodates a part of the pod drainage piping 62 and a part of the cup drainage piping 63.

The pod drainage piping 62 is a tubular member. One end of the pod drainage piping 62 is connected to the bottom portion of the liquid receiving portion 11. The processing liquid collected in the liquid receiving portion 11 flows into the pod drainage piping 62. The pod drainage piping 62 extends from the bottom portion of the liquid receiving portion 11 to the outside of the processing chamber 200a.

The cup drainage piping 63 is a tubular member. One end of the cup drainage piping 63 is connected to the bottom portion of the cup portion 7. Specifically, one end of the cup drainage piping 63 is connected to the bottom portion of the cup liquid receiving portion 72. The processing liquid collected in the cup portion 7 (cup liquid receiving portion 72) flows into the cup drainage piping 63. The cup drainage piping 63 extends from the bottom portion of the cup portion 7 (cup liquid receiving portion 72) to the outside of the processing chamber 200a.

The liquid supply mechanism 8 is controlled by the controller 101 (controlling portion 102) to selectively supply a plurality of types of processing liquids to the nozzle 3. Specifically, the liquid supply mechanism 8 includes a supply piping 81. The supply piping 81 is a tubular member. One end of the supply piping 81 is connected to the nozzle 3. The supply piping 81 allows the processing liquid to flow to the nozzle 3. When the processing liquid flows to the nozzle 3 through the supply piping 81, the processing liquid is discharged from the nozzle 3. The processing chamber 200a accommodates a part of the supply piping 81. The supply piping 81 extends from the nozzle 3 to the outside of the processing chamber 200a.

The suck back mechanism 9 is controlled by the controller 101 (controlling portion 102) to perform a suck back process. The suck back process indicates a process of drawing the processing liquid from the nozzle 3 to the supply piping **81.** The suck back process is performed when the discharge of the processing liquid by the nozzle 3 is stopped. More specifically, the suck back process is performed when the supply of the processing liquid by the liquid supply mechanism 8 is stopped. Specifically, the suck back process is performed after the discharge of the plurality of types of processing liquids from the nozzle 3 to the substrate W is completed. Specifically, the suck back mechanism 9 includes a suck back piping 91 and a suck back valve 92.

One end of the suck back piping 91 is connected to the supply piping 81. The processing chamber 200a accommodates a part of the suck back piping 91. The suck back piping 91 extends from a connection point SP between the suck back piping 91 and the supply piping 81 to the outside of the processing chamber 200a.

The suck back valve 92 is provided in the suck back piping 91. The suck back valve 92 can change the volume of the internal flow path of the suck back valve 92. The controller 101 (controlling portion 102) enlarges the internal flow path of the suck back valve 92 at the time of the suck back process. When the internal flow path of the suck back valve 92 becomes large, the processing liquid staying between the suck back valve 92 and the connection point SP flows to the downstream side of the suck back piping 91, and the processing liquid staying between the tip of the nozzle 3 and the connection point SP is drawn into the suck back piping 91 from the connection point SP. As a result, the processing liquid is sucked back (retreated) from the nozzle 3 to the supply piping 81. Furthermore, the controller 101 (controlling portion 102) reduces the volume of the internal flow path of the suck back valve 92 while the suck back process is not performed.

Next, the liquid supply mechanism 8 will be further described. As illustrated in FIG. 2, the liquid supply mechanism 8 further includes a switching valve 82, a multiple valve 83, a first piping CP1 to a sixth piping CP6, and a first opening/closing valve VA1 to a fifth opening/closing valve VA5 in addition to the supply piping 81. The switching valve 82, the multiple valve 83, the first piping CP1 to the sixth piping CP6, and the first opening/closing valve VA1 to the fifth opening/closing valve VA5 are located outside the processing chamber 200a. In the present preferred embodiment, the liquid supply mechanism 8 selectively supplies DHF (acid chemical liquid), SC1 (alkaline chemical liquid), and DIW (rinse liquid) to the nozzle 3.

The supply piping 81 is connected to the secondary side of the switching valve 82. One end of the first piping CP1 and one end of the sixth piping CP6 are connected to the primary side of the switching valve 82. One end of the second piping CP2 is connected to the first piping CP1. Each one end of the third piping CP3 to the fifth piping CP5 is connected to the primary side of the multiple valve 83. The other end of the sixth piping CP6 is connected to the secondary side of the multiple valve 83.

The first opening/closing valve VA1 to the fifth opening/closing valve VA5 are provided in the first piping CP1 to the fifth piping CP5, respectively. The first opening/closing valve VA1 to the fifth opening/closing valve VA5 can be switched between an open state and a closed state. The open/closed state of each of the first opening/closing valve VA1 to the fifth opening/closing valve VA5 is controlled by the controller 101 (controlling portion 102). While the first opening/closing valve VA1 to the fifth opening/closing valve VA5 are in the closed state, the supply of the processing liquid from the liquid supply mechanism 8 to the nozzle 3 is stopped.

The first piping CP1 selectively allows DHF and DIW to flow to the switching valve 82. The second piping CP2 allows DIW to flow to the first piping CP1. Specifically, when the first opening/closing valve VA1 is opened and the second opening/closing valve VA2 is closed, DHF flows to the switching valve 82 through the first piping CP1. Also, when the second opening/closing valve VA2 is opened and the first opening/closing valve VA1 is closed, DIW flows to the switching valve 82 through the second piping CP2 and the first piping CP1. In this manner, the first opening/closing valve VA1 controls the supply of DHF to the primary side of the switching valve 82 and the stop of the supply of DHF to the primary side of the switching valve 82. Also, the second opening/closing valve VA2 controls the supply of DIW to the primary side of the switching valve 82 and the stop of the supply of DIW to the primary side of the switching valve 82.

The third piping CP3 allows ammonia water (NH₄OH) to flow to the multiple valve 83. Specifically, when the third opening/closing valve VA3 is opened, the ammonia water flows to the multiple valve 83 through the third piping CP3. In this manner, the third opening/closing valve VA3 controls the supply of the ammonia water to the primary side of the multiple valve 83 and the stop of the supply of the ammonia water to the primary side of the multiple valve 83.

Similarly, the fourth piping CP4 allows hydrogen peroxide (H₂O₂) to flow to the multiple valve 83. The fifth piping CP5 allows DIW to flow to the multiple valve 83. The fourth opening/closing valve VA4 controls the supply of the hydrogen peroxide to the primary side of the multiple valve 83 and the stop of the supply of the hydrogen peroxide to the primary side of the multiple valve 83. Also, the fifth opening/closing valve VA5 controls the supply of DIW to the primary side of the multiple valve 83 and the stop of the supply of DIW to the primary side of the multiple valve 83.

When SC1 is supplied to the nozzle 3, the controller 101 (controlling portion 102) opens the third opening/closing valve VA3 to the fifth opening/closing valve VA5, and supplies ammonia water, hydrogen peroxide, and DIW to the multiple valve 83. As a result, the ammonia water, the hydrogen peroxide, and DIW are mixed in the multiple valve 83 to generate SC1. The sixth piping CP6 allows SC1 to flow from the multiple valve 83 to the switching valve 82. That is, the sixth piping CP6 supplies SC1 to the switching valve 82.

The switching valve 82 is controlled by the controller 101 (controlling portion 102) to selectively supply DHF (acid chemical liquid), SC1 (alkaline chemical liquid), and DIW (rinse liquid) to the supply piping 81. Specifically, when DHF or DIW is supplied to the supply piping 81, the switching valve 82 is controlled by the controller 101 (controlling portion 102) to allow the supply piping 81 and the first piping CP1 to communicate with each other. Also, when SC1 is supplied to the supply piping 81, the switching valve 82 is controlled by the controller 101 (controlling portion 102) to allow the supply piping 81 and the sixth piping CP6 to communicate with each other.

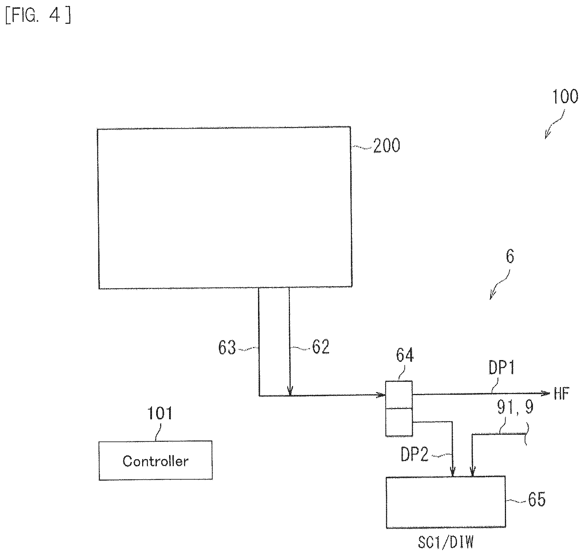

Next, the drainage mechanism 6 will be described with reference to FIGS. 1 to 4. FIG. 4 is a view schematically illustrating the configuration of the drainage mechanism 6 included in the substrate processing apparatus 100 according to the present preferred embodiment. As illustrated in FIG. 4, the drainage mechanism 6 further includes a switching valve 64 in addition to the pod drainage piping 62 and the cup drainage piping 63. The substrate processing apparatus 100 further includes a first drainage piping DP1, a second drainage piping DP2, and a drainage tank 65.

The drainage mechanism 6 guides an acid chemical liquid (DHF) discharged from the liquid receiving portion 11 (see FIGS. 2 and 3) at the time of the pre-dispensing process to the first drainage piping DP1. Also, the drainage mechanism 6 guides an alkaline chemical liquid (SC1) and a rinse liquid (DIW) discharged from the liquid receiving portion 11 (see FIGS. 2 and 3) at the time of the pre-dispensing process to the second drainage piping DP2.

Further, the drainage mechanism 6 guides the acid chemical liquid (DHF) discharged from the cup portion 7 (see FIGS. 2 and 3) at the time of the substrate processing to the first drainage piping DP1. Also, the drainage mechanism 6 guides the alkaline chemical liquid (SC1) and the rinse liquid (DIW) discharged from the cup portion 7 (see FIGS. 2 and 3) at the time of the substrate processing to the second drainage piping DP2.

Specifically, the other end of the cup drainage piping 63 is connected to the primary side of the switching valve 64. The other end of the pod drainage piping 62 is connected to the cup drainage piping 63. Therefore, the processing liquid discharged from the liquid receiving portion 11 at the time of the pre-dispensing process flows into the cup drainage piping 63 from the pod drainage piping 62, and flows to the switching valve 64 through the cup drainage piping 63. Also, the processing liquid discharged from the cup portion 7 at the time of the substrate processing flows to the switching valve 64 through the cup drainage piping 63.

One end of the first drainage piping DP1 and one end of the second drainage piping DP2 are connected to the secondary side of the switching valve 64. The switching valve 64 is controlled by the controller 101 (controlling portion 102) to supply an acid chemical liquid (DHF) to the first drainage piping DP1 and to supply an alkaline chemical liquid (SC1) and a rinse liquid (DIW) to the second drainage piping DP2. Specifically, when DHF is supplied to the first drainage piping DP1, the switching valve 64 is controlled by the controller 101 (controlling portion 102) to allow the cup drainage piping 63 and the first drainage piping DP1 to communicate with each other. Also, when SC1 or DIW is supplied to the second drainage piping DP2, the switching valve 64 is controlled by the controller 101 (controlling portion 102) to allow the cup drainage piping 63 and the second drainage piping DP2 to communicate with each other.

The other end of the second drainage piping DP2 is connected to the drainage tank 65. The alkaline chemical liquid (SC1) and the rinse liquid (DIW) flow into the drainage tank 65 from the second drainage piping DP2. The drainage tank 65 is an example of a "liquid tank."

In the present preferred embodiment, the other end of the suck back piping 91 is connected to the drainage tank 65. Therefore, the suck back mechanism 9 allows the sucked processing liquid to flow to the drainage tank 65. Therefore, the processing liquid sucked back by the suck back mechanism 9 flows into the drainage tank 65.

In the present preferred embodiment, the controller 101 (controlling portion 102) performs the suck back process after the second supply of the rinse liquid (DIW) from the nozzle 3 to the substrate W is stopped. Therefore, the suck back mechanism 9 allows the sucked rinse liquid (DIW) to flow to the drainage tank 65. That is, the rinse liquid (DIW) sucked back by the suck back mechanism 9 flows into the drainage tank 65.

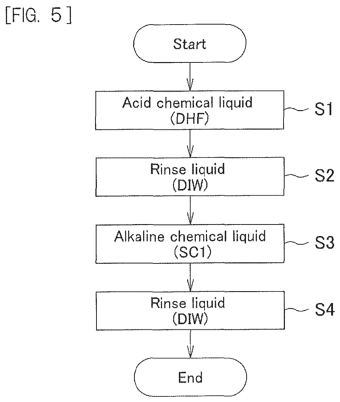

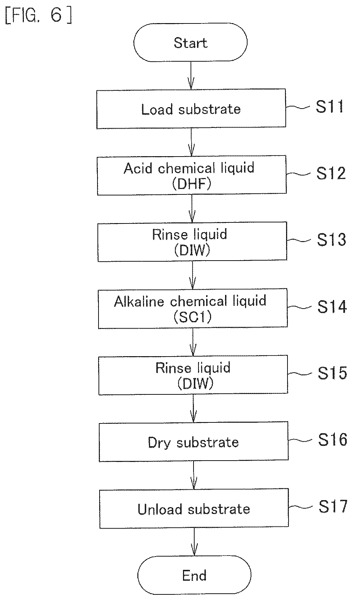

Next, a substrate processing method according to the present preferred embodiment will be described with reference to FIGS. 1 to **6****.** The substrate processing method according to the present preferred embodiment includes a method of pre-dispensing (pre-discharging) the processing liquid from the nozzle 3 and a method of processing the substrate W. FIG. 5 is a flowchart illustrating a method of pre-dispensing (pre-discharging) the processing liquid from the nozzle **3.** FIG. 6 is a flowchart illustrating a method of processing the substrate **W.** The substrate processing method illustrated in FIGS. 5 and 6 is performed by the substrate processing apparatus 100 described with reference to FIGS. 1 to 4. Therefore, FIGS. 5 and 6 illustrate the operation of the substrate processing apparatus 100 according to the present preferred embodiment.

As illustrated in FIG. 5, the controller 101 (controlling portion 102) allows the nozzle 3 located at the standby position PS2 to selectively discharge an acid chemical liquid (DHF), an alkaline chemical liquid (SC1), and a rinse liquid (DIW) at the time of the pre-dispensing process.

Specifically, when starting the pre-dispensing process, the controller 101 (controlling portion 102) allows the nozzle 3 located at the standby position PS2 to discharge an acid chemical liquid (DHF) (step S1). The acid chemical liquid (DHF) discharged from the nozzle 3 is received by the liquid receiving portion 11. The acid chemical liquid (DHF) discharged from the liquid receiving portion 11 is guided to the first drainage piping DP1 by the drainage mechanism 6.

After discharging the acid chemical liquid (DHF), the controller 101 (controlling portion 102) allows the nozzle 3 located at the standby position PS2 to discharge a rinse liquid (DIW) (step S2). The rinse liquid (DIW) discharged from the nozzle 3 is received by the liquid receiving portion 11. Then, the rinse liquid (DIW) discharged from the liquid receiving portion 11 is guided to the second drainage piping DP2 by the drainage mechanism 6.

After discharging the rinse liquid (DIW), the controller 101 (controlling portion 102) allows the nozzle 3 located at the standby position PS2 to discharge an alkaline chemical liquid (SC1) (step S3). The alkaline chemical liquid (SC1) discharged from the nozzle 3 is received by the liquid receiving portion 11. Then, the alkaline chemical liquid (SC1) discharged from the liquid receiving portion 11 is guided to the second drainage piping DP2 by the drainage mechanism 6.

After discharging the alkaline chemical liquid (SC1), the controller 101 (controlling portion 102) allows the nozzle 3 located at the standby position PS2 to discharge the rinse liquid (DIW) again (step S4). As a result, the pre-dispensing process illustrated in FIG. 5 ends. Similarly to the step S2, the rinse liquid (DIW) discharged from the nozzle 3 is guided to the second drainage piping DP2.

After the completion of the pre-dispensing process, substrate processing is performed. Specifically, as illustrated in FIG. 6, the controller 101 (controlling portion 102) controls the center robot CR to load the substrate W into the processing chamber 200a (step S11). Then, the controller 101 (controlling portion 102) allows the substrate holding portion 2 to hold the substrate W. When the substrate holding portion 2 holds the substrate W, the controller 101 (controlling portion 102) controls the elevating/lowering portion 73 to move the cup portion 7 from the lower position to the upper position.

After moving the cup portion 7 from the lower position to the upper position, the controller 101 (controlling portion 102) controls the substrate rotating portion 4 to rotate the substrate W. Also, the controller 101 (controlling portion 102) controls the nozzle moving portion 5 to move the nozzle 3 from the standby position PS2 to the processing position PS1. When the rotation speed of the substrate W reaches a predetermined rotation speed, the controller 101 (controlling portion 102) controls the liquid supply mechanism 8 to selectively discharge an acid chemical liquid (DHF), an alkaline chemical liquid (SC1), and a rinse liquid (DIW) from the nozzle 3 toward the rotating substrate W.

Specifically, when the substrate processing is started, the controller 101 (controlling portion 102) controls the liquid supply mechanism 8 to supply an acid chemical liquid (DHF) to the nozzle 3. As a result, the acid chemical liquid (DHF) is discharged from the nozzle 3, and the acid chemical liquid (DHF) is supplied to the rotating substrate W (step S12).

The controller 101 (controlling portion 102) allows the nozzle 3 to supply the acid chemical liquid (DHF) to the substrate W until a first predetermined time elapses after the start of discharge of the acid chemical liquid (DHF). As a result, a liquid film of the acid chemical liquid (DHF) is formed on the upper surface of the substrate W. The acid chemical liquid (DHF) discharged from the substrate W during the supply of the acid chemical liquid (DHF) is received by the cup portion 7. The acid chemical liquid (DHF) received by the cup portion 7 is guided to the first drainage piping DP1 by the drainage mechanism 6.

When the first predetermined period elapses, the controller 101 (controlling portion 102) controls the liquid supply mechanism 8 to switch the processing liquid to be supplied to the nozzle 3 from the acid chemical liquid (DHF) to a rinse liquid (DIW). As a result, the rinse liquid (DIW) is discharged from the nozzle 3, and the rinse liquid (DIW) is supplied to the rotating substrate W (step S13).

The controller 101 (controlling portion 102) allows the nozzle 3 to supply the rinse liquid (DIW) to the substrate W until a second predetermined time elapses after the start of the discharge of the rinse liquid (DIW). As a result, a liquid film of the rinse liquid (DIW) is formed on the upper surface of the substrate W. In other words, the liquid film of the acid chemical liquid (DHF) on the upper surface of the substrate W is replaced with the liquid film of the rinse liquid (DIW). The rinse liquid (DIW) discharged from the substrate W during the supply of the rinse liquid (DIW) is received by the cup portion 7. The rinse liquid (DIW) received by the cup portion 7 is guided to the second drainage piping DP2 by the drainage mechanism 6. As a result, the rinse liquid (DIW) flows into the drainage tank 65 through the second drainage piping DP2.

When the second predetermined period elapses, the controller 101 (controlling portion 102) controls the liquid supply mechanism 8 to switch the processing liquid to be supplied to the nozzle 3 from the rinse liquid (DIW) to an alkaline chemical liquid (SC1). As a result, the alkaline chemical liquid (SC1) is discharged from the nozzle 3, and the alkaline chemical liquid (SC1) is supplied to the rotating substrate W (step S14).

The controller 101 (controlling portion 102) allows the nozzle 3 to supply the alkaline chemical liquid (SC1) to the substrate W until a third predetermined time elapses from the start of the discharge of the alkaline chemical liquid (SC1). As a result, a liquid film of the alkaline chemical liquid (SC1) is formed on the upper surface of the substrate W. In other words, the liquid film of the rinse liquid (DIW) on the upper surface of the substrate W is replaced with the liquid film of the alkaline chemical liquid (SC1). The alkaline chemical liquid (SC1) discharged from the substrate W during the supply of the alkaline chemical liquid (SC1) is received by the cup portion 7. The alkaline chemical liquid (SC1) received by the cup portion 7 is guided to the second drainage piping DP2 by the drainage mechanism 6. As a result, the alkaline chemical liquid (SC1) flows into the drainage tank 65 through the second drainage piping DP2.

When the third predetermined period elapses, the controller 101 (controlling portion 102) controls the liquid supply mechanism 8 to switch the processing liquid to be supplied to the nozzle 3 from the alkaline chemical liquid (SC1) to the rinse liquid (DIW). As a result, the rinse liquid (DIW) is discharged from the nozzle 3, and the rinse liquid (DIW) is supplied to the rotating substrate W (step S15).

The controller 101 (controlling portion 102) allows the nozzle 3 to supply the rinse liquid (DIW) to the substrate W until a fourth predetermined time elapses after the start of the discharge of the rinse liquid (DIW). As a result, a liquid film of the rinse liquid (DIW) is formed on the upper surface of the substrate W. In other words, the liquid film of the alkaline chemical liquid (SC1) on the upper surface of the substrate W is replaced with the liquid film of the rinse liquid (DIW). The rinse liquid (DIW) discharged from the substrate W during the supply of the rinse liquid (DIW) is received by the cup portion 7. The rinse liquid (DIW) received by the cup portion 7 is guided to the second drainage piping DP2 by the drainage mechanism 6. As a result, the rinse liquid (DIW) flows into the drainage tank 65 through the second drainage piping DP2.

When the fourth predetermined time elapses, the controller 101 (controlling portion 102) controls the substrate rotating portion 4 to increase the rotation speed of the substrate W. As a result, the substrate W is dried (step S16). Also, the controller 101 (controlling portion 102) controls the nozzle moving portion 5 to move the nozzle 3 from the processing position PS1 to the standby position PS2. When a fifth predetermined time elapses after the rotation speed of the substrate W was increased, the controller 101 (controlling portion 102) controls the substrate rotating portion 4 to stop the rotation of the substrate **W.**

When stopping the rotation of the substrate W, the controller 101 (controlling portion 102) controls the elevating/lowering portion 73 to move the cup portion 7 from the upper position to the lower position. When the cup portion 7 moves to the lower position, the controller 101 (controlling portion 102) controls the substrate holding portion 2 to release the holding of the substrate **W.** Then, the controller 101 (controlling portion 102) controls the center robot CR to unload the substrate W to the outside of the processing chamber 200a (step S17). As a result, the process illustrated in FIG. 6 ends.

As described above with reference to FIGS. 1 to 6, according to the present preferred embodiment, a plurality of types of processing liquids can be selectively discharged from the same nozzle (nozzle 3). Therefore, when the type of the processing liquid to be supplied to the substrate W is switched, the supply of the processing liquid to the substrate W is not interrupted. Therefore, when the type of the processing liquid to be supplied to the substrate W is switched, the outer peripheral portion of the substrate W is less likely to become uncovered with the liquid film.

Furthermore, according to the present preferred embodiment, the acid chemical liquid, the alkaline chemical liquid, and the rinse liquid discharged at the time of the pre-dispensing process can be guided to the same drainage piping as the acid chemical liquid, the alkaline chemical liquid, and the rinse liquid discharged at the time of the substrate processing, respectively. As a result, it is possible to avoid mixing of the acid chemical liquid and the alkaline chemical liquid in the drainage tank 65. Therefore, it is possible to avoid damage to the drainage tank 65 due to a reaction between the acid chemical liquid and the alkaline chemical liquid in the drainage tank 65.

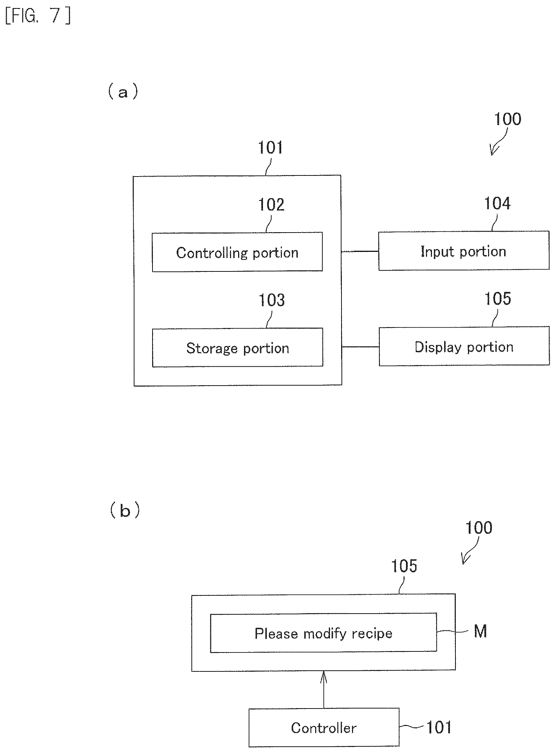

Next, the substrate processing apparatus 100 according to the present preferred embodiment will be described with reference to FIGS. 1 to 8. FIG. 7(a) is a block diagram illustrating a part of the configuration of the substrate processing apparatus 100 according to the present preferred embodiment. FIG. 7(b) is a diagram illustrating an error message M displayed on a display portion 105 included in the substrate processing apparatus 100 according to the present preferred embodiment. As illustrated in FIG. 7(a), the substrate processing apparatus 100 further includes an input portion 104 and the display portion 105.

The input portion 104 is a user interface device operated by an operator. The input portion 104 inputs an instruction (control signal) corresponding to the operation of the operator to the controlling portion 102. Also, the input portion 104 inputs data corresponding to the operation of the operator to the controlling portion 102. The input portion 104 typically includes a keyboard and a mouse. Furthermore, the input portion 104 may include a touch sensor. The touch sensor is superposed on the display surface of the display portion 105 and generates a signal indicating a touch operation on the display surface by the operator. The operator can input various instructions to the controlling portion 102 by a touch operation.

For example, the input portion 104 is operated by the operator to input the first discharge order and the second discharge order. As described above, the first discharge order indicates an order of discharging a plurality of types of processing liquids from the nozzle 3 toward the substrate W at the time of the substrate processing. The second discharge order indicates an order of discharging a plurality of types of processing liquids from the nozzle 3 toward the liquid receiving portion 11 at the time of the pre-dispensing process. Specifically, the operator operates the input portion 104 to create the pre-recipe YRP and the process recipe SRP.

The display portion 105 displays various screens. The display portion 105 is typically a display device such as a liquid crystal display device or an organic electroluminescence (EL) display device. For example, the display portion 105 selectively displays an input screen of the pre-recipe YRP and an input screen of the process recipe SRP.

In the present preferred embodiment, the storage portion 103 stores a first prohibition rule that is a prohibition rule of the first discharge order and a second prohibition rule that is a prohibition rule of the second discharge order. The first prohibition rule indicates a rule for prohibiting the setting of the discharge order of discharging the alkaline chemical liquid after discharging the acid chemical liquid. Similarly, the second prohibition rule indicates a rule for prohibiting the setting of the discharge order of discharging the alkaline chemical liquid after discharging the acid chemical liquid.

When the operator operates the input portion 104 to input the first discharge order corresponding to the first prohibition rule, the controlling portion 102 does not accept the setting of the first discharge order. Similarly, when the operator operates the input portion 104 to input the second discharge order corresponding to the second prohibition rule, the controlling portion 102 does not accept the setting of the second discharge order.

Specifically, when the operator operates the input portion 104 to input the process recipe SRP that defines the first discharge order corresponding to the first prohibition rule, the controlling portion 102 does not accept the setting of the process recipe SRP. Similarly, when the operator operates the input portion 104 to input the pre-recipe YRP that defines the second discharge order corresponding to the second prohibition rule, the controlling portion 102 does not accept the setting of the pre-recipe YRP.

The controlling portion 102 may allow the display portion 105 to display an error message M when the first discharge order corresponding to the first prohibition rule is input. Similarly, the controlling portion 102 may allow the display portion 105 to display an error message M when the second discharge order corresponding to the second prohibition rule is input. As illustrated in FIG. 7(b), the error message M may indicate that, for example, a recipe created by an operator needs to be corrected.

Specifically, when the process recipe SRP that defines the first discharge order corresponding to the first prohibition rule is input, the controlling portion 102 may allow the display portion 105 to display the error message M. Similarly, when the pre-recipe YRP that defines the second discharge order corresponding to the second prohibition rule is input, the controlling portion 102 may allow the display portion 105 to display the error message M.

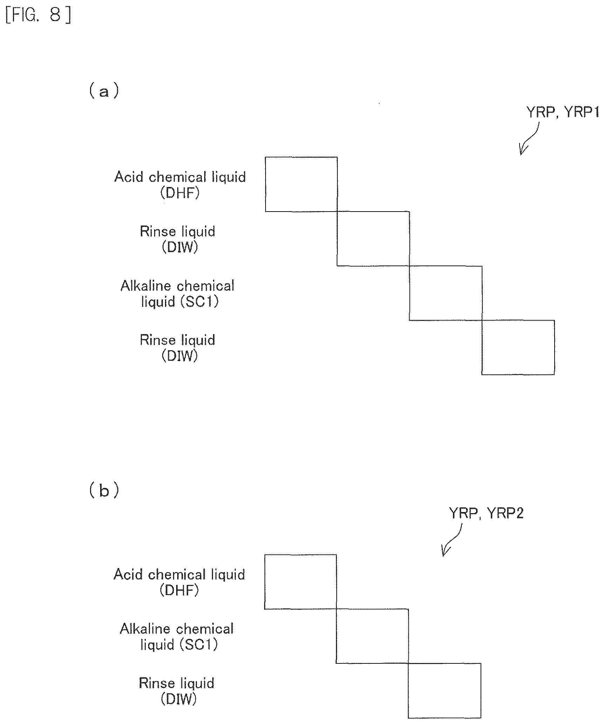

Here, the second prohibition rule will be described with reference to FIGS. 8(a) and 8(b). FIG. 8(a) is a diagram schematically illustrating a first example of the pre-recipe YRP. FIG. 8(b) is a diagram schematically illustrating a second example of the pre-recipe YRP. Hereinafter, the first example of the pre-recipe YRP may be referred to as a "first pre-recipe YRP1." Also, the second example of the pre-recipe YRP may be referred to as a "second pre-recipe YRP2."

As illustrated in FIG. 8(a), the first pre-recipe YRP1 defines that an acid chemical liquid, an alkaline chemical liquid, and a rinse liquid are discharged in the order of the acid chemical liquid, the rinse liquid, the alkaline chemical liquid, and the rinse liquid. Therefore, the second discharge order of the first pre-recipe YRP1 does not indicate the discharge order of discharging the alkaline chemical liquid after discharging the acid chemical liquid, and thus does not correspond to the second prohibition rule. Therefore, the controlling portion 102 accepts the setting of the first pre-recipe YRP1 (second discharge order). Furthermore, also in a case where the process recipe SRP that defines the first discharge order not corresponding to the first prohibition rule is input, the controlling portion 102 similarly accepts the setting of the process recipe SRP (first discharge order).

On the other hand, as illustrated in FIG. 8(b), the second pre-recipe YRP2 defines that an acid chemical liquid, an alkaline chemical liquid, and a rinse liquid are discharged in the order of the acid chemical liquid, the alkaline chemical liquid, and the rinse liquid. Therefore, the second discharge order of the second pre-recipe YRP2 indicates the discharge order of discharging the alkaline chemical liquid after discharging the acid chemical liquid, and thus corresponds to the second prohibition rule. Therefore, the controlling portion 102 does not accept the setting of the second pre-recipe YRP2 (second discharge order), and allows the display portion 105 to display the error message M as described with reference to FIG. 7(b).

Furthermore, also in a case where the process recipe SRP that defines the first discharge order corresponding to the first prohibition rule is input, similarly, the controlling portion 102 does not accept the setting of the process recipe SRP (first discharge order), and allows the display portion 105 to display the error message M as described with reference to FIG. 7(b).

According to the present preferred embodiment, since the alkaline chemical liquid is not discharged after discharge of the acid chemical liquid, it is possible to avoid damage to the cup portion 7 due to a reaction between the acid chemical liquid and the alkaline chemical liquid in the cup portion 7, for example, at the time of the substrate processing. Similarly, it is possible to avoid damage to the liquid receiving portion 11 due to a reaction between the acid chemical liquid and the alkaline chemical liquid in the liquid receiving portion 11, for example, at the time of the pre-dispensing process.

Next, the substrate processing apparatus 100 according to the present preferred embodiment will be described with reference to FIGS. 1 to 7 and 9. In the present preferred embodiment, the storage portion 103 further stores a third prohibition rule. The third prohibition rule indicates a rule for prohibiting the operation of the suck back mechanism 9 when the processing liquid finally discharged from the nozzle 3 at the time of the substrate processing is a processing liquid other than the rinse liquid. Specifically, when the operator operates the input portion 104 to input the process recipe SRP that defines the first discharge order corresponding to the third prohibition rule, the controlling portion 102 does not perform the suck back process.

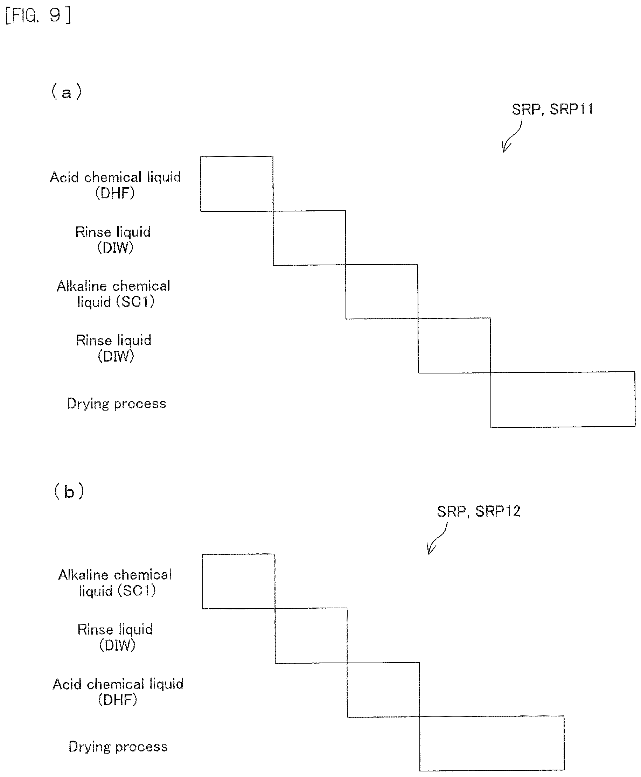

Here, the third prohibition rule will be described with reference to FIGS. 9(a) and 9(b). FIG. 9(a) is a diagram schematically illustrating a first example of the process recipe SRP. FIG. 9(b) is a diagram schematically illustrating a second example of the process recipe SRP. Hereinafter, the first example of the process recipe SRP may be referred to as a "first process recipe SRP11." Also, the second example of the process recipe SRP may be referred to as a "second process recipe SRP12."

As illustrated in FIG. 9(a), the first process recipe SRP11 defines a discharge order (first discharge order) in which a rinse liquid (DIW) is finally discharged from the nozzle 3 at the time of the substrate processing. Therefore, the first process recipe SRP11 does not correspond to the third rule. Therefore, after the second discharge of the rinse liquid from the nozzle 3, the controlling portion 102 operates the suck back mechanism 9 to perform the suck back process.

On the other hand, as illustrated in FIG. 9(b), the second process recipe SRP12 defines a discharge order (first discharge order) in which an acid chemical liquid (DHF) is finally discharged from the nozzle 3 at the time of the substrate processing. Therefore, the second process recipe SRP12 corresponds to the third prohibition rule. Therefore, the controlling portion 102 does not operate the suck back mechanism 9 after the acid chemical liquid (DHF) is discharged from the nozzle 3. That is, the controlling portion 102 does not perform the suck back process.

According to the present preferred embodiment, when the processing liquid finally discharged from the nozzle 3 in the first discharge order is a processing liquid other than the rinse liquid, only the rinse liquid flows into the drainage tank 65 from the suck back mechanism 9 since the operation of the suck back mechanism 9 is prohibited. Therefore, it is possible to avoid damage to the drainage tank 65 due to a reaction between the acid chemical liquid and the alkaline chemical liquid in the drainage tank 65.

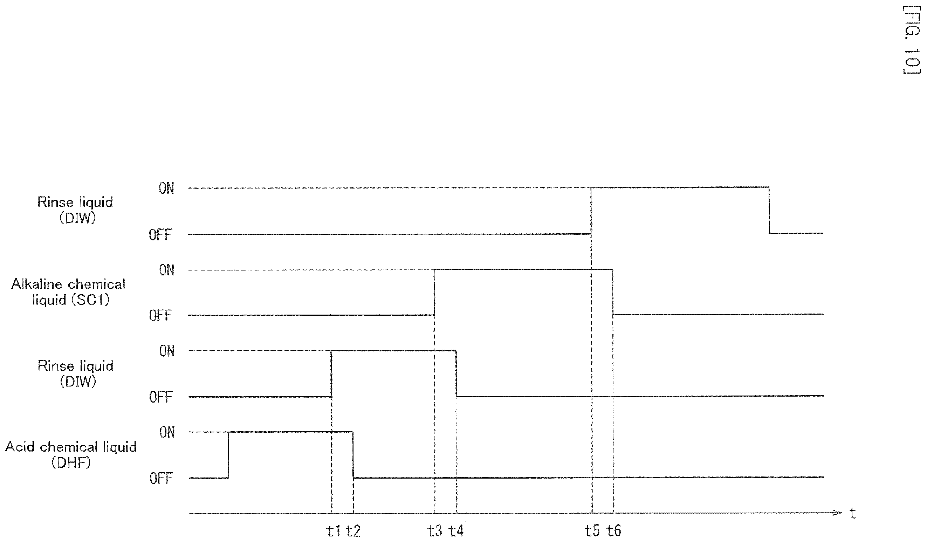

Next, the substrate processing apparatus 100 according to the present preferred embodiment will be described with reference to FIGS. 1 to 6 and 10. FIG. 10 is a diagram illustrating a timing of supplying the processing liquid to the nozzle 3. In FIG. 10, the horizontal axis represents a time t. Also, in FIG. 10, "ON" indicates that the processing liquid is supplied to the nozzle 3, and "OFF" indicates that the supply of the processing liquid to the nozzle 3 is stopped.

In the present preferred embodiment, the controller 101 (controlling portion 102) stops the discharge of the processing liquid at a timing different from the discharge stop timing of the processing liquid defined by the process recipe SRP. Specifically, the controller 101 (controlling portion 102) stops the discharge of the processing liquid at a timing delayed from the discharge stop timing of the processing liquid defined by the process recipe SRP.

Specifically, when controlling the supply of the processing liquid to the nozzle 3 to switch the type of the processing liquid to be discharged from the nozzle 3 to the substrate W, the controller 101 (controlling portion 102) delays the supply stop timing of the processing liquid previously discharged from the nozzle 3 and simultaneously supplies the two types of processing liquids to the nozzle 3 for a certain period of time. That is, the controller 101 (controlling portion 102) controls the liquid supply mechanism 8 to delay the supply stop timing of the processing liquid.

Specifically, as illustrated in FIG. 10, the controller 101 (controlling portion 102) starts the first supply of the rinse liquid (DIW) at a time t1, and then stops the supply of the acid chemical liquid (DHF) at a time t2. Therefore, from the time t1 to the time t2, the acid chemical liquid (DHF) and the rinse liquid (DIW) are simultaneously supplied to the nozzle 3 for a certain period of time. Therefore, the acid chemical liquid (DHF) and the rinse liquid (DIW) are simultaneously discharged from the nozzle 3.

Similarly, the controller 101 (controlling portion 102) starts the supply of the alkaline chemical liquid (SC1) at a time t3, and then stops the first supply of the rinse liquid (DIW) at a time t4. Therefore, from the time t3 to the time t4, the rinse liquid (DIW) and the alkaline chemical liquid (SC1) are simultaneously supplied to the nozzle 3 for a certain period of time. Therefore, the rinse liquid (DIW) and the alkaline chemical liquid (SC1) are simultaneously discharged from the nozzle 3.

Also, the controller 101 (controlling portion 102) starts the second supply of the rinse liquid (DIW) at a time t5, and then stops the supply of the alkaline chemical liquid (SC1) at a time t6. Therefore, from the time t5 to the time t6, the rinse liquid (DIW) and the alkaline chemical liquid (SC1) are simultaneously supplied to the nozzle 3 for a certain period of time. Therefore, the rinse liquid (DIW) and the alkaline chemical liquid (SC1) are simultaneously discharged from the nozzle 3.

According to the present preferred embodiment, the supply of the next processing liquid can be started before the discharge of the processing liquid previously discharged from the nozzle 3 is stopped. Therefore, when the type of the processing liquid to be supplied to the substrate W is switched, the supply of the processing liquid to the substrate W is less likely to be interrupted. Therefore, when the type of the processing liquid to be supplied to the substrate W is switched, the outer peripheral portion of the substrate W is less likely to become uncovered with the liquid film.

### [Second Preferred Embodiment]

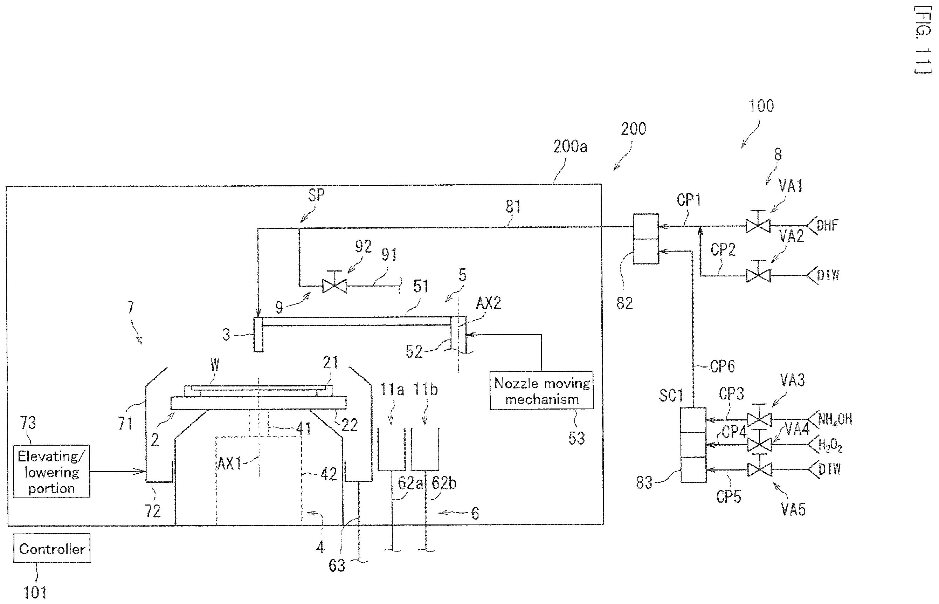

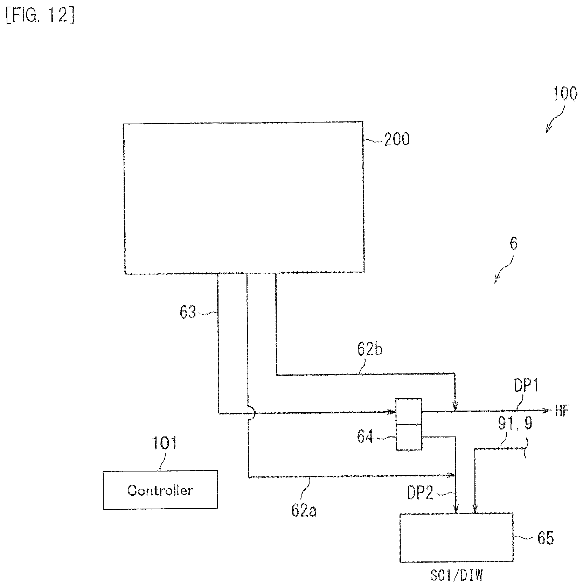

Next, a second preferred embodiment of the present invention will be described with reference to FIGS. 11 and 12. However, matters different from those in the first preferred embodiment will be described, and description of the same matters as those in the first preferred embodiment will be omitted. In the second preferred embodiment, unlike the first preferred embodiment, the substrate processing portion 200 includes a first liquid receiving portion 11a and a second liquid receiving portion 11b. Also, the second preferred embodiment is different from the first preferred embodiment in the configuration of the drainage mechanism 6.

FIG. 11 is a view schematically illustrating an internal configuration of the substrate processing portion 200, a configuration of the drainage mechanism 6, and a configuration of the liquid supply mechanism 8 included in the substrate processing apparatus 100 according to the present preferred embodiment. As illustrated in FIG. 11, in the present preferred embodiment, the substrate processing portion 200 includes a first liquid receiving portion 11a and a second liquid receiving portion 11b. Also, the drainage mechanism 6 includes a first pod drainage piping 62a and a second pod drainage piping 62b.

The first liquid receiving portion 11a and the second liquid receiving portion 11b are located outside the substrate holding portion 2. In the present preferred embodiment, the first liquid receiving portion 11a and the second liquid receiving portion 11b are located outside the cup portion 7. The first liquid receiving portion 11a receives the alkaline chemical liquid and the rinse liquid discharged from the nozzle 3 at the time of the pre-dispensing process. The second liquid receiving portion 11b receives the acid chemical liquid discharged from the nozzle 3 at the time of the pre-dispensing process. The first liquid receiving portion 11a and the second liquid receiving portion 11b are, for example, standby pods.

The first pod drainage piping 62a and the second pod drainage piping 62b are tubular members. One end of the first pod drainage piping 62a is connected to the bottom portion of the first liquid receiving portion 11a. The processing liquid collected in the first liquid receiving portion 11a flows into the first pod drainage piping 62a. The first pod drainage piping 62a extends from the bottom portion of the first liquid receiving portion 11a to the outside of the processing chamber 200a. Similarly, one end of the second pod drainage piping 62b is connected to the bottom portion of the second liquid receiving portion 11b. The processing liquid collected in the second liquid receiving portion 11b flows into the second pod drainage piping 62b. The second pod drainage piping 62b extends from the bottom portion of the second liquid receiving portion 11b to the outside of the processing chamber 200a.

FIG. 12 is a view schematically illustrating the configuration of the drainage mechanism 6 included in the substrate processing apparatus 100 according to the present preferred embodiment. In the present preferred embodiment, the drainage mechanism 6 guides the alkaline chemical liquid (SC1) and the rinse liquid (DIW) discharged from the first liquid receiving portion 11a (see FIG. 11) at the time of the pre-dispensing process to the second drainage piping DP2. Also, the drainage mechanism 6 guides the acid chemical liquid (DHF) discharged from the second liquid receiving portion 11b (see FIG. 11) at the time of the pre-dispensing process to the first drainage piping DP1.

Specifically, the other end of the first pod drainage piping 62a described with reference to FIG. 11 is connected to the second drainage piping DP2. Also, the other end of the second pod drainage piping 62b described with reference to FIG. 11 is connected to the first drainage piping DP1.

Therefore, the alkaline chemical liquid (SC1) and the rinse liquid (DIW) discharged from the first liquid receiving portion 11a at the time of the pre-dispensing process are guided to the second drainage piping DP2 through the first pod drainage piping 62a. As a result, the alkaline chemical liquid (SC1) and the rinse liquid (DIW) discharged from the nozzle 3 at the time of the pre-dispensing process flow into the drainage tank 65. Also, the acid chemical liquid (DHF) discharged from the second liquid receiving portion 11b at the time of the pre-dispensing process is guided to the first drainage piping DP1 through the second pod drainage piping 62b.

The second preferred embodiment of the present invention has been described above with reference to FIGS. 11 and 12. According to the second preferred embodiment, similarly to the first preferred embodiment, when the type of the processing liquid to be supplied to the substrate W is switched, the outer peripheral portion of the substrate W is less likely to become uncovered with the liquid film. Also, similarly to the first preferred embodiment, it is possible to avoid damage to the drainage tank 65 due to a reaction between the acid chemical liquid and the alkaline chemical liquid in the drainage tank 65.

### [Third Preferred Embodiment]

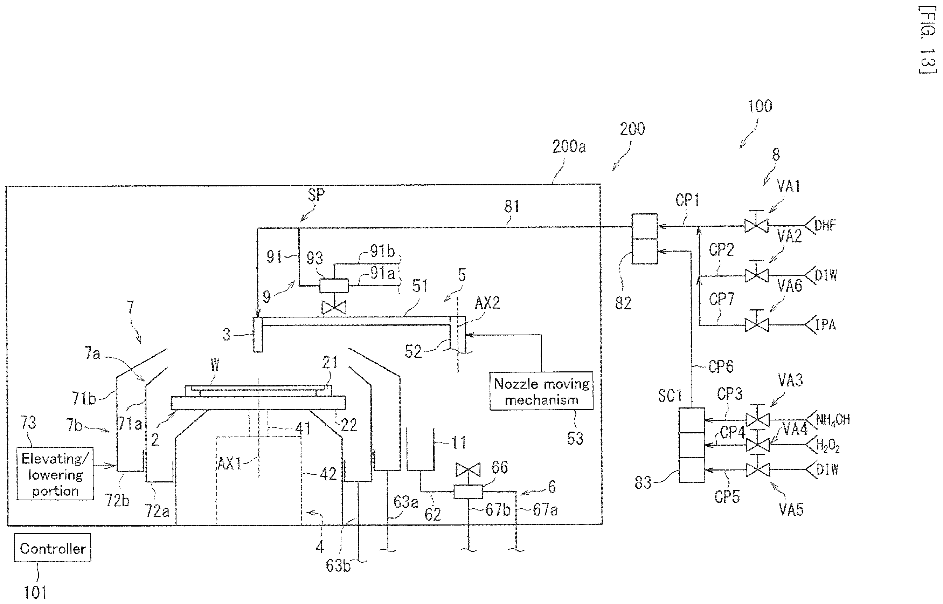

Next, a third preferred embodiment of the present invention will be described with reference to FIGS. 13 to 16. However, matters different from those in the first and second preferred embodiments will be described, and description of the same matters as those in the first and second preferred embodiments will be omitted. In the third preferred embodiment, unlike the first and second preferred embodiments, the cup portion 7 includes a first cup portion 7a and a second cup portion 7b. Also, the third preferred embodiment is different from the first and second preferred embodiments in the configuration of the drainage mechanism 6, the configuration of the suck back mechanism 9, and the configuration of the liquid supply mechanism 8.

FIG. 13 is a view schematically illustrating an internal configuration of the substrate processing portion 200, a configuration of the drainage mechanism 6, and a configuration of the liquid supply mechanism 8 included in the substrate processing apparatus 100 according to the present preferred embodiment. As illustrated in FIG. 13, in the substrate processing apparatus 100 according to the present preferred embodiment, the liquid supply mechanism 8 selectively supplies DHF, SC1, DIW, and isopropyl alcohol (IPA) to the nozzle 3. Therefore, the nozzle 3 selectively discharges DHF (acid chemical liquid), SC1 (alkaline chemical liquid), DIW (rinse liquid), and IPA. IPA is an example of an organic solvent.

Specifically, the liquid supply mechanism 8 further includes a sixth opening/closing valve VA6 and a seventh piping CP7. The sixth opening/closing valve VA6 and the seventh piping CP7 are located outside the processing chamber 200a. One end of the seventh piping CP7 is connected to the second piping CP2. The sixth opening/closing valve VA6 is provided in the seventh piping CP7. The sixth opening/closing valve VA6 can be switched between an open state and a closed state. The open/closed state of the sixth opening/closing valve VA6 is controlled by the controller 101 (controlling portion 102). In the present preferred embodiment, while the first opening/closing valve VA1 to the sixth opening/closing valve VA6 are in the closed state, the supply of the processing liquid from the liquid supply mechanism 8 to the nozzle 3 is stopped.

The seventh piping CP7 allows IPA to flow to the second piping CP2. In the present preferred embodiment, the first piping CP1 selectively allows DHF, DIW, and IPA to flow to the switching valve 82. The second piping CP2 selectively allows DIW and IPA to flow to the first piping CP1.

Specifically, when the first opening/closing valve VA1 is opened and the second opening/closing valve VA2 and the sixth opening/closing valve VA6 are closed, DHF flows to the switching valve 82 through the first piping CP1. Also, when the second opening/closing valve VA2 is opened and the first opening/closing valve VA1 and the sixth opening/closing valve VA6 are closed, DIW flows to the switching valve 82 through the second piping CP2 and the first piping CP1. Similarly, when the sixth opening/closing valve VA6 is opened and the first opening/closing valve VA1 and the second opening/closing valve VA2 are closed, IPA flows to the switching valve 82 through the seventh piping CP7, the second piping CP2, and the first piping CP1. In this manner, the sixth opening/closing valve VA6 controls the supply of IPA to the primary side of the switching valve 82 and the stop of the supply of IPA to the primary side of the switching valve 82.

The switching valve 82 is controlled by the controller 101 (controlling portion 102) to selectively supply DHF (acid chemical liquid), SC1 (alkaline chemical liquid), DIW (rinse liquid), and IPA (organic solvent) to the supply piping 81. Specifically, when DHF, DIW, or IPA is supplied to the supply piping 81, the switching valve 82 is controlled by the controller 101 (controlling portion 102) to allow the supply piping 81 and the first piping CP1 to communicate with each other. Also, when SC1 is supplied to the supply piping 81, the switching valve 82 is controlled by the controller 101 (controlling portion 102) to allow the supply piping 81 and the sixth piping CP6 to communicate with each other.

The cup portion 7 includes a first cup portion 7a and a second cup portion 7b. The first cup portion 7a includes a first guard portion 71a and a first cup liquid receiving portion 72a. The second cup portion 7b includes a second guard portion 71b and a second cup liquid receiving portion 72b. Since the configuration of the first cup portion 7a is similar to that of the cup portion 7 described with reference to FIG. 2, the detailed description thereof will be omitted.

The second guard portion 71b is located outside the first guard portion 71a. The second guard portion 71b has a substantially tubular shape. In other words, the second guard portion 71b surrounds the first guard portion 71a.

The second cup liquid receiving portion 72b is coupled to the lower end portion of the second guard portion 71b. The second cup liquid receiving portion 72b has an annular shape, and forms an annular groove inside the second guard portion 71b. Similarly to the cup portion 7 described with reference to FIG. 2, the processing liquid received by the second guard portion 71b is collected in the groove of the second cup liquid receiving portion 72b.

The elevating/lowering portion 73 individually elevates and lowers the first cup portion 7a and the second cup portion 7b. When the first cup portion 7a receives the processing liquid discharged from the substrate W, the elevating/lowering portion 73 moves the first cup portion 7a to the upper position. When the second cup portion 7b receives the processing liquid discharged from the substrate W, the elevating/lowering portion 73 allows the first cup portion 7a to stand by at the lower position. As a result, the second guard portion 71b receives the processing liquid scattered from the rotating substrate W.

Specifically, the controller 101 (controlling portion 102) retracts the first cup portion 7a to the lower position at the time of the substrate processing. Also, the controller 101 (controlling portion 102) moves the first cup portion 7a to the upper position at the time of the drying process. Therefore, the second cup portion 7b receives the processing liquid discharged from the substrate W at the time of the substrate processing. The first cup portion 7a receives the processing liquid discharged from the substrate W at the time of the drying process.

The drainage mechanism 6 includes the pod drainage piping 62, a first cup drainage piping 63a, a second cup drainage piping 63b, a branch portion 66, a first branch piping 67a, and a second branch piping 67b. The processing chamber 200a accommodates the pod drainage piping 62, a part of the first cup drainage piping 63a, a part of the second cup drainage piping 63b, the branch portion 66, a part of the first branch piping 67a, and a part of the second branch piping 67b.

The pod drainage piping 62 is a tubular member. One end of the pod drainage piping 62 is connected to the bottom portion of the liquid receiving portion 11. The processing liquid collected in the liquid receiving portion 11 flows into the pod drainage piping 62. The other end of the pod drainage piping 62 is connected to the branch portion 66.

The first cup drainage piping 63a is a tubular member. One end of the first cup drainage piping 63a is connected to the bottom portion of the second cup portion 7b. Specifically, one end of the first cup drainage piping 63a is connected to the bottom portion of the second cup liquid receiving portion 72b. The processing liquid collected in the second cup portion 7b (second cup liquid receiving portion 72b) flows into the first cup drainage piping 63a. The first cup drainage piping 63a extends from the bottom portion of the second cup portion 7b (second cup liquid receiving portion 72b) to the outside of the processing chamber 200a.

The second cup drainage piping 63b is a tubular member. One end of the second cup drainage piping 63b is connected to the bottom portion of the first cup portion 7a. Specifically, one end of the second cup drainage piping 63b is connected to the bottom portion of the first cup liquid receiving portion 72a. The processing liquid collected in the first cup portion 7a (first cup liquid receiving portion 72a) flows into the second cup drainage piping 63b. The second cup drainage piping 63b extends from the bottom portion of the first cup portion 7a (first cup liquid receiving portion 72a) to the outside of the processing chamber 200a.

One end of the first branch piping 67a and one end of the second branch piping 67b are connected to the branch portion 66. The first branch piping 67a and the second branch piping 67b are tubular members. The branch portion 66 is controlled by the controller 101 (controlling portion 102) to communicate the pod drainage piping 62 with one of the first branch piping 67a and the second branch piping 67b. The first branch piping 67a and the second branch piping 67b extend from the branch portion 66 to the outside of the processing chamber 200a.

When allowing the processing liquid collected by the liquid receiving portion 11 to flow into the first branch piping 67a, the controller 101 (controlling portion 102) controls the branch portion 66 to allow the pod drainage piping 62 to communicate with the first branch piping 67a. Similarly, when allowing the processing liquid collected by the liquid receiving portion 11 to flow into the second branch piping 67b, the controller 101 (controlling portion 102) controls the branch portion 66 to allow the pod drainage piping 62 to communicate with the second branch piping 67b.

The suck back mechanism 9 includes the suck back piping 91, a first branch piping 91a, a second branch piping 91b, and a suck back valve 93. One end of the suck back piping 91 is connected to the supply piping 81. The suck back piping 91 extends from the connection point SP between the suck back piping 91 and the supply piping 81 to the suck back valve 93. The processing chamber 200a accommodates the suck back piping 91.

One end of the first branch piping 91a and one end of the second branch piping 91b are connected to the suck back valve 93. The first branch piping 91a and the second branch piping 91b are tubular members. Similarly to the suck back valve 92 described with reference to FIG. 2, the suck back valve 93 sucks back (retreats) the processing liquid from the nozzle 3 to the supply piping 81. The processing chamber 200a accommodates the suck back valve 93.

Furthermore, the suck back valve 93 is controlled by the controller 101 (controlling portion 102) to allow the suck back piping 91 to communicate with one of the first branch piping 91a and the second branch piping 91b. The processing chamber 200a accommodates a part of the first branch piping 91a and a part of the second branch piping 91b. The first branch piping 91a and the second branch piping 91b extend from the suck back valve 93 to the outside of the processing chamber 200a.

When allowing the sucked processing liquid to flow into the first branch piping 91a, the controller 101 (controlling portion 102) controls the suck back valve 93 to allow the suck back piping 91 to communicate with the first branch piping 91a. Similarly, when allowing the sucked processing liquid to flow into the second branch piping 91b, the controller 101 (controlling portion 102) controls the suck back valve 93 to allow the suck back piping 91 to communicate with the second branch piping 91b.

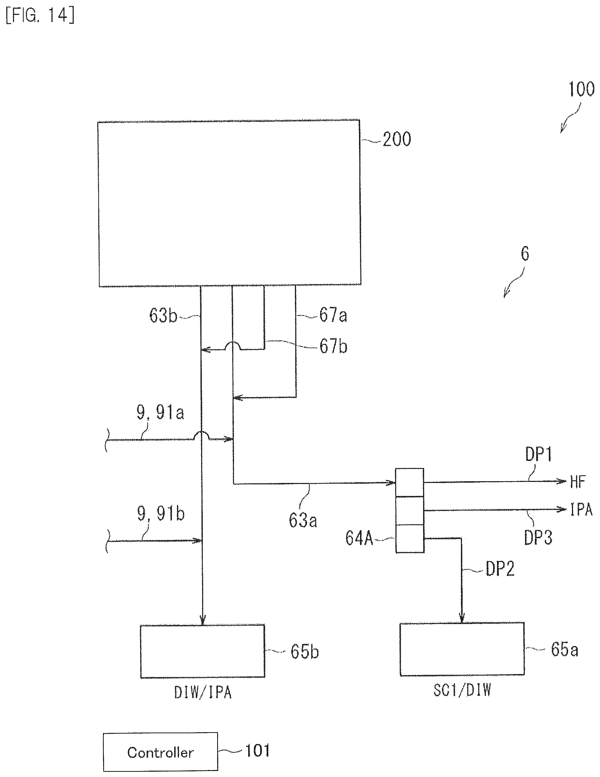

Next, the drainage mechanism 6 will be described with reference to FIG. 14. FIG. 14 is a view schematically illustrating the configuration of the drainage mechanism 6 included in the substrate processing apparatus 100 according to the present preferred embodiment. As illustrated in FIG. 14, the drainage mechanism 6 further includes a switching valve 64A. Also, the substrate processing apparatus 100 further includes the first drainage piping DP1, the second drainage piping DP2, a third drainage piping DP3, a first drainage tank 65a, and a second drainage tank 65b.

The drainage mechanism 6 guides the acid chemical liquid (DHF) discharged from the liquid receiving portion 11 (see FIG. 13) at the time of the pre-dispensing process to the first drainage piping DP1. Also, the drainage mechanism 6 guides the alkaline chemical liquid (SC1) and the rinse liquid (DIW) discharged from the liquid receiving portion 11 (FIG. 13) at the time of the pre-dispensing process to the second drainage piping DP2. Further, the drainage mechanism 6 guides the organic solvent (IPA) discharged from the liquid receiving portion 11 (FIG. 13) at the time of the pre-dispensing process to the third drainage piping DP3.

Further, the drainage mechanism 6 guides the acid chemical liquid (DHF) discharged from the second cup portion 7b (see FIG. 13) at the time of the substrate processing to the first drainage piping DP1. Also, the drainage mechanism 6 guides the alkaline chemical liquid (SC1) and the rinse liquid (DIW) discharged from the second cup portion 7b (see FIG. 13) at the time of the substrate processing to the second drainage piping DP2. Further, the drainage mechanism 6 guides the organic solvent (IPA) discharged from the second cup portion 7b (see FIG. 13) at the time of the substrate processing to the third drainage piping DP3.

Specifically, the other end of the first cup drainage piping 63a is connected to the primary side of the switching valve 64A. The other end of the first branch piping 67a is connected to the first cup drainage piping 63a. Therefore, the processing liquid discharged from the liquid receiving portion 11 at the time of the pre-dispensing process flows from the first branch piping 67a into the first cup drainage piping 63a, and flows to the switching valve 64A through the first cup drainage piping 63a. Also, the processing liquid discharged from the second cup portion 7b at the time of the substrate processing flows to the switching valve 64A through the first cup drainage piping 63a.

One end of the first drainage piping DP1, one end of the second drainage piping DP2, and one end of the third drainage piping DP3 are connected to the secondary side of the switching valve 64A. The switching valve 64A is controlled by the controller 101 (controlling portion 102) to supply an acid chemical liquid (DHF) to the first drainage piping DP1, supply an alkaline chemical liquid (SC1) and a rinse liquid (DIW) to the second drainage piping DP2, and supply an organic solvent (IPA) to the third drainage piping DP3.

Specifically, when DHF is supplied to the first drainage piping DP1, the switching valve 64A is controlled by the controller 101 (controlling portion 102) to allow the first cup drainage piping 63a and the first drainage piping DP1 to communicate with each other. Also, when SC1 or DIW is supplied to the second drainage piping DP2, the switching valve 64A is controlled by the controller 101 (controlling portion 102) to allow the first cup drainage piping 63a and the second drainage piping DP2 to communicate with each other. Also, when IPA is supplied to the third drainage piping DP3, the switching valve 64A is controlled by the controller 101 (controlling portion 102) to allow the first cup drainage piping 63a and the third drainage piping DP3 to communicate with each other.

The other end of the second drainage piping DP2 is connected to the first drainage tank 65a. The alkaline chemical liquid (SC1) and the rinse liquid (DIW) flow into the first drainage tank 65a from the second drainage piping DP2. The first drainage tank 65a is an example of a "liquid tank."

The other end of the first branch piping 91a of the suck back mechanism 9 is connected to the first cup drainage piping 63a. In the present preferred embodiment, the organic solvent (IPA) is sucked back. At the time of the suck back process, the drainage mechanism 6 guides the sucked organic solvent (IPA) to the third drainage piping DP3. Specifically, the controller 101 (controlling portion 102) controls the switching valve 64A to allow the first cup drainage piping 63a to communicate with the third drainage piping DP3. As a result, the organic solvent (IPA) flowing from the suck back mechanism 9 (first branch piping 91a) into the first cup drainage piping 63a flows into the third drainage piping DP3.

The other end of the second cup drainage piping 63b is connected to the second drainage tank 65b. The second cup drainage piping 63b allows the processing liquid discharged from the substrate W at the time of the drying process to flow. Therefore, the processing liquid discharged from the substrate W at the time of the drying process flows into the second drainage tank 65b. In the present preferred embodiment, the processing liquid discharged from the substrate W at the time of the drying process is an organic solvent (IPA). Therefore, the organic solvent (IPA) flows into the second drainage tank 65b at the time of the drying process.

In the present preferred embodiment, the other end of the second branch piping 67b is connected to the second cup drainage piping 63b. Therefore, when discharging the organic solvent (IPA) from the nozzle 3 at the time of the pre-dispensing process, the controller 101 (controlling portion 102) may control the branch portion 66 (see FIG. 13) to allow the pod drainage piping 62 (see FIG. 13) and the second branch piping 67b to communicate with each other. Furthermore, when discharging the rinse liquid (DIW) from the nozzle 3 at the time of the pre-dispensing process, the controller 101 (controlling portion 102) may control the branch portion 66 (see FIG. 13) to allow the pod drainage piping 62 (see FIG. 13) and the second branch piping 67b to communicate with each other.

Also, in the present preferred embodiment, the other end of the second branch piping 91b of the suck back mechanism 9 is connected to the second cup drainage piping 63b. Therefore, the controller 101 (controlling portion 102) may control the suck back valve 93 at the time of the suck back process to allow the suck back piping 91 (see FIG. 13) and the second branch piping 91b to communicate with each other.

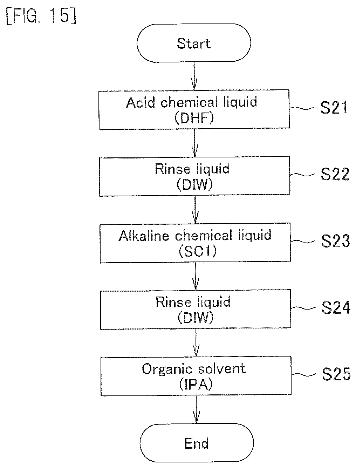

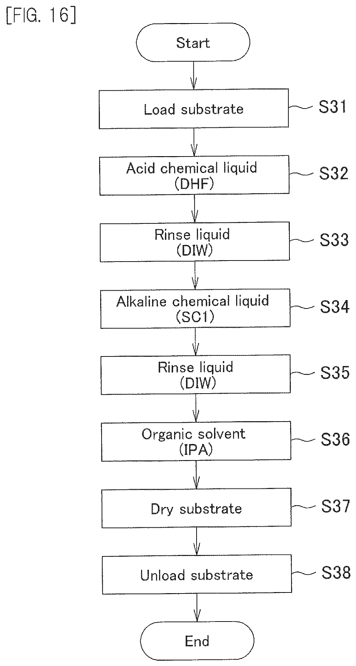

Next, a substrate processing method according to the present preferred embodiment will be described with reference to FIGS. 13 to 16. The substrate processing method according to the present preferred embodiment includes a method of pre-dispensing (pre-discharging) the processing liquid from the nozzle 3 and a method of processing the substrate W. FIG. 15 is a flowchart illustrating a method of pre-dispensing (pre-discharging) the processing liquid from the nozzle 3. FIG. 16 is a flowchart illustrating a method of processing the substrate W. The substrate processing method illustrated in FIGS. 15 and 16 is performed by the substrate processing apparatus 100 illustrated in FIGS. 1, 13, and 14. Therefore, FIGS. 15 and 16 illustrate the operation of the substrate processing apparatus 100 according to the present preferred embodiment.

As illustrated in FIG. 15, the controller 101 (controlling portion 102) allows the nozzle 3 located at the standby position PS2 to selectively discharge an acid chemical liquid (DHF), an alkaline chemical liquid (SC1), a rinse liquid (DIW), and an organic solvent (IPA) at the time of the pre-dispensing process. Specifically, the pre-dispensing process illustrated in FIG. 15 includes steps S21 to S25. Here, since the processes of steps S21 to S24 are similar to those of steps S1 to S4 described with reference to FIG. 5, the description thereof is omitted.

After the second discharge of the rinse liquid (DIW) (step S24), the controller 101 (controlling portion 102) allows the nozzle 3 located at the standby position PS2 to discharge the organic solvent (IPA) (step S25). As a result, the pre-dispensing process illustrated in FIG. 15 ends. The organic solvent (IPA) discharged from the nozzle 3 is received by the liquid receiving portion 11. Then, the organic solvent (IPA) discharged from the liquid receiving portion 11 is guided to the third drainage piping DP3 by the drainage mechanism 6.

After the completion of the pre-dispensing process, substrate processing is performed. Specifically, as illustrated in FIG. 16, the controller 101 (controlling portion 102) controls the center robot CR to load the substrate W into the processing chamber 200a (step S31). Then, the controller 101 (controlling portion 102) allows the substrate holding portion 2 to hold the substrate W. When the substrate holding portion 2 holds the substrate W, the controller 101 (controlling portion 102) controls the elevating/lowering portion 73 to move the second cup portion 7b from the lower position to the upper position.

The processes of steps S32 to S35 illustrated in FIG. 16 are similar to those of steps S12 to S35 described with reference to FIG. 6 except that the second cup portion 7b receives the processing liquid discharged from the substrate W, and thus the description thereof is omitted.

When the fourth predetermined time elapses after the start of the second discharge of the rinse liquid (DIW), the controller 101 (controlling portion 102) controls the liquid supply mechanism 8 to switch the processing liquid to be supplied to the nozzle 3 from the rinse liquid (DIW) to the organic solvent (IPA). As a result, the organic solvent (IPA) is discharged from the nozzle 3, and the organic solvent (IPA) is supplied to the rotating substrate W (step S36).

The controller 101 (controlling portion 102) allows the nozzle 3 to supply the organic solvent (IPA) to the substrate W until a sixth predetermined time elapses after the start of the discharge of the organic solvent (IPA). As a result, a liquid film of the organic solvent (IPA) is formed on the upper surface of the substrate W. In other words, the liquid film of the rinse liquid (DIW) on the upper surface of the substrate W is replaced with the liquid film of the organic solvent (IPA). The organic solvent (IPA) discharged from the substrate W during the supply of the organic solvent (IPA) is received by the second cup portion 7b. The organic solvent (IPA) received by the second cup portion 7b is guided to the third drainage piping DP3 by the drainage mechanism 6.

When the sixth predetermined time elapses, the controller 101 (controlling portion 102) controls the elevating/lowering portion 73 to move the first cup portion 7a from the lower position to the upper position. When the first cup portion 7a moves to the upper position, the controller 101 (controlling portion 102) controls the substrate rotating portion 4 to increase the rotation speed of the substrate W. As a result, the substrate W is dried (step S37). Also, the controller 101 (controlling portion 102) controls the nozzle moving portion 5 to move the nozzle 3 from the processing position PS1 to the standby position PS2. When a fifth predetermined time elapses after the rotation speed of the substrate W was increased, the controller 101 (controlling portion 102) controls the substrate rotating portion 4 to stop the rotation of the substrate W.

In the present preferred embodiment, the organic solvent (IPA) discharged from the substrate W at the time of the drying process is received by the first cup portion 7a. The organic solvent (IPA) received by the first cup portion 7a is guided to the second drainage tank 65b by the drainage mechanism 6.

When stopping the rotation of the substrate W, the controller 101 (controlling portion 102) controls the elevating/lowering portion 73 to move the first cup portion 7a and the second cup portion 7b from the upper position to the lower position. When the first cup portion 7a and the second cup portion 7b move to the lower position, the controller 101 (controlling portion 102) controls the substrate holding portion 2 to release the holding of the substrate W. Then, the controller 101 (controlling portion 102) controls the center robot CR to unload the substrate W to the outside of the processing chamber 200a (step S38). As a result, the process illustrated in FIG. 16 ends.

The third preferred embodiment of the present invention has been described above with reference to FIGS. 13 to 16. According to the third preferred embodiment, similarly to the first and second preferred embodiments, when the type of the processing liquid to be supplied to the substrate W is switched, the outer peripheral portion of the substrate W is less likely to become uncovered with the liquid film. Also, similarly to the first and second preferred embodiments, it is possible to avoid damage to the first drainage tank 65a due to a reaction between the acid chemical liquid and the alkaline chemical liquid in the first drainage tank 65a.

In the third preferred embodiment, similarly to the first and second preferred embodiments, the setting of the discharge order (the first discharge order and the second discharge order) of discharging the alkaline chemical liquid after discharging the acid chemical liquid may be prohibited. Also, when the type of the processing liquid to be discharged from the nozzle 3 to the substrate W is switched, the supply stop timing of the processing liquid previously discharged from the nozzle 3 may be delayed, and the two types of processing liquids may be simultaneously supplied to the nozzle 3 for a certain period of time.

### [Fourth Preferred Embodiment]

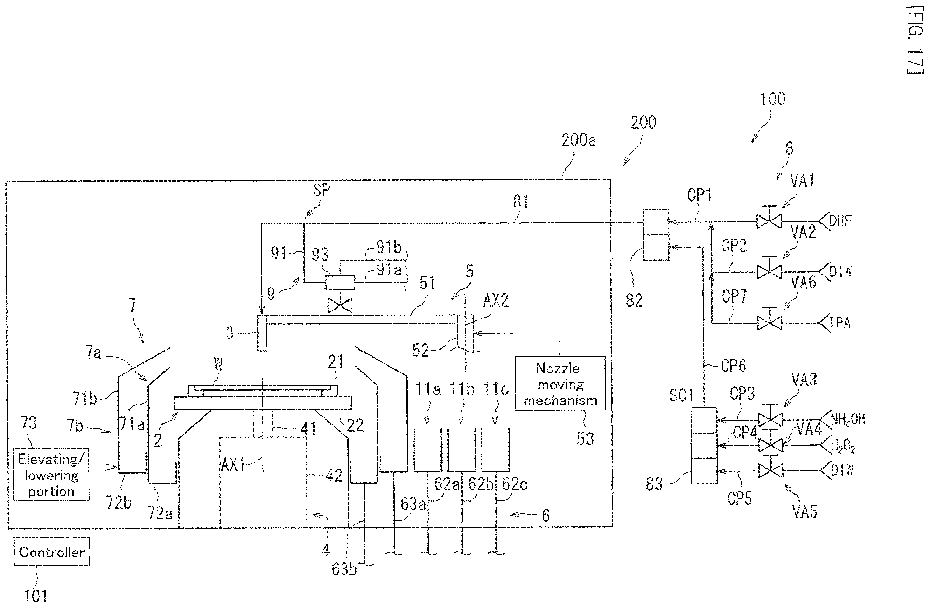

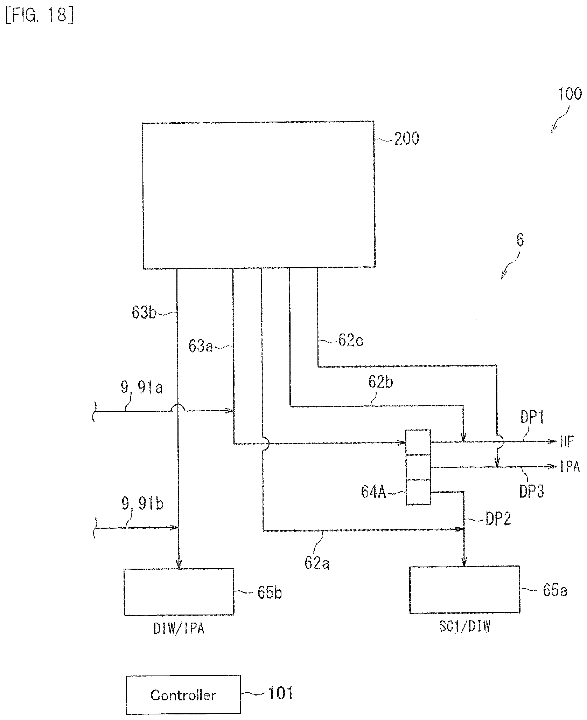

Next, a fourth preferred embodiment of the present invention will be described with reference to FIGS. 17 and 18. However, matters different from those in the first to third preferred embodiments will be described, and description of the same matters as those in the first to third preferred embodiments will be omitted. In the fourth preferred embodiment, unlike the first to third preferred embodiments, the substrate processing portion 200 includes the first liquid receiving portion 11a to a third liquid receiving portion 11c. Also, the fourth preferred embodiment is different from the first to third preferred embodiments in the configuration of the drainage mechanism 6.

FIG. 17 is a view schematically illustrating an internal configuration of the substrate processing portion 200, a configuration of the drainage mechanism 6, and a configuration of the liquid supply mechanism 8 included in the substrate processing apparatus 100 according to the present preferred embodiment. In the fourth preferred embodiment, similarly to the third preferred embodiment, an acid chemical liquid (DHF), an alkaline chemical liquid (SC1), a rinse liquid (DIW), and an organic solvent (IPA) are selectively discharged from the nozzle 3. Also, similarly to the third preferred embodiment, the cup portion 7 includes the first cup portion 7a and the second cup portion 7b.

As illustrated in FIG. 17, in the present preferred embodiment, the substrate processing portion 200 includes the first liquid receiving portion 11a to a third liquid receiving portion 11c. Also, the drainage mechanism 6 includes the first pod drainage piping 62a to a third pod drainage piping 62c.

The first liquid receiving portion 11a to the third liquid receiving portion 11c are located outside the substrate holding portion 2. In the present preferred embodiment, the first liquid receiving portion 11a to the third liquid receiving portion 11c are located outside the cup portion 7. The first liquid receiving portion 11a receives the alkaline chemical liquid and the rinse liquid discharged from the nozzle 3 at the time of the pre-dispensing process. The second liquid receiving portion 11b receives the acid chemical liquid discharged from the nozzle 3 at the time of the pre-dispensing process. The third liquid receiving portion 11c receives the organic solvent discharged from the nozzle 3 at the time of the pre-dispensing process. The first liquid receiving portion 11a to the third liquid receiving portion 11c are, for example, standby pods.

The configurations of the first pod drainage piping 62a and the second pod drainage piping 62b are similar to those of the first pod drainage piping 62a and the second pod drainage piping 62b described with reference to FIG. 11, and thus the description thereof is omitted here. The third pod drainage piping 62c is a tubular member. One end of the third pod drainage piping 62c is connected to the bottom portion of the third liquid receiving portion 11c. The processing liquid (organic solvent) collected in the third liquid receiving portion 11c flows into the third pod drainage piping 62c. The third pod drainage piping 62c extends from the bottom portion of the third liquid receiving portion 11c to the outside of the processing chamber 200a.

FIG. 18 is a view schematically illustrating the configuration of the drainage mechanism 6 included in the substrate processing apparatus 100 according to the present preferred embodiment. In the present preferred embodiment, the drainage mechanism 6 guides the alkaline chemical liquid (SC1) and the rinse liquid (DIW) discharged from the first liquid receiving portion 11a (see FIG. 17) at the time of the pre-dispensing process to the second drainage piping DP2. Also, the drainage mechanism 6 guides the acid chemical liquid (DHF) discharged from the second liquid receiving portion 11b (see FIG. 17) at the time of the pre-dispensing process to the first drainage piping DP1. In the present preferred embodiment, the drainage mechanism 6 guides the organic solvent (IPA) discharged from the third liquid receiving portion 11c (see FIG. 17) at the time of the pre-dispensing process to the third drainage piping DP3.

Specifically, similarly to the second preferred embodiment, the other end of the first pod drainage piping 62a described with reference to FIG. 17 is connected to the second drainage piping DP2. Also, the other end of the second pod drainage piping 62b described with reference to FIG. 17 is connected to the first drainage piping DP1.

In the present preferred embodiment, the other end of the third pod drainage piping 62c described with reference to FIG. 17 is connected to the third drainage piping DP3. Therefore, the organic solvent (IPA) discharged from the third liquid receiving portion 11c at the time of the pre-dispensing process is guided to the third drainage piping DP3 through the third pod drainage piping 62c.

The fourth preferred embodiment of the present invention has been described above with reference to FIGS. 17 and 18. According to the fourth preferred embodiment, similarly to the first to third preferred embodiments, when the type of the processing liquid to be supplied to the substrate W is switched, the outer peripheral portion of the substrate W is less likely to become uncovered with the liquid film. Also, similarly to the first to third preferred embodiments, it is possible to avoid damage to the first drainage tank 65a due to a reaction between the acid chemical liquid and the alkaline chemical liquid in the first drainage tank 65a.

The preferred embodiments of the present invention have been described above with reference to the drawings (FIGS. 1 to 18). However, the present invention is not limited to the preferred embodiments described above and can be implemented in various modes within a scope not deviating from its gist. Also, it is possible to modify, as appropriate, the plurality of constituent elements disclosed in the preferred embodiments described above. For example, a certain constituent element among all constituent elements of a certain preferred embodiment may be added to the constituent elements of another preferred embodiment or some constituent elements among all constituent elements of a certain preferred embodiment may be deleted from the preferred embodiment.

The drawings mainly illustrate the respective constituent elements schematically to facilitate understanding of the invention and there are cases where thicknesses, lengths, numbers, intervals, etc., of the respective constituent elements illustrated differ from the actual ones due to convenience of drawing preparation. Also, the arrangements of the respective constituent elements indicated in the preferred embodiments described above are but an example, are not restricted in particular, and can obviously be changed variously within a scope of practically not deviating from the effects of the present invention.

For example, in the preferred embodiments described with reference to FIGS. 1 to 18, the substrate holding portion 2 is a gripping type chuck that brings the plurality of chuck members 21 into contact with the peripheral end surface of the substrate W. However, a method of holding the substrate W is not particularly limited as long as the substrate W can be horizontally held. For example, the substrate holding portion 2 may be a vacuum type chuck or a Bernoulli type chuck.

Also, in the preferred embodiments described with reference to FIGS. 1 to 18, the rinse liquid is pure water, but the rinse liquid is not limited to pure water. The rinse liquid may be, for example, carbonated water, electrolyzed ion water, hydrogen water, ozone water, or hydrochloric acid water having a dilution concentration (for example, about 10 ppm to 100 ppm).

Also, in the preferred embodiments described with reference to FIGS. 1 to 18, the operator creates the pre-recipe YRP (second discharge order). However, the controller 101 (controlling portion 102) may generate the pre-recipe YRP (second discharge order) based on the first discharge order defined in the process recipe SRP. For example, the controller 101 (controlling portion 102) may generate the second discharge order such that the discharge order of the plurality of types of processing liquids at the time of the pre-dispensing process is the same as the discharge order (first discharge order) of the plurality of types of processing liquids at the time of the substrate processing.

### Industrial Applicability

The present invention is useful for an apparatus to process a substrate and a method of processing a substrate.

### Reference Signs List

- 2 :: substrate holding portion
- 3: : nozzle
- 5: : nozzle moving portion
- 6: : drainage mechanism
- 7: : cup portion
- 7a: : first cup portion
- 7b: : second cup portion
- 8: : liquid supply mechanism
- 9: : suck back mechanism
- 11: : liquid receiving portion
- 11a: : first liquid receiving portion
- 11b: : second liquid receiving portion
- 11c: : third liquid receiving portion
- 65: : drainage tank
- 65a: : first drainage tank
- 81: : supply piping
- 91: : suck back piping
- 100: : substrate processing apparatus
- 101: : controller
- 102: : controlling portion
- 104: : input portion
- DP1: : first drainage piping
- DP2: : second drainage piping
- DP3: : third drainage piping
- PS1: : processing position
- PS2: : standby position
- SRP: : process recipe
- SRP11: : first process recipe
- SRP12: : second process recipe
- W: : substrate
- YRP: : pre-recipe
- YRP1: : first pre-recipe
- YRP2: : second pre-recipe

## Claims

1. A substrate processing apparatus comprising:
a nozzle to selectively discharge a plurality of types of processing liquids including an acid chemical liquid, an alkaline chemical liquid, and a rinse liquid;
a substrate holding portion to hold a substrate;
a liquid receiving portion, located outside the substrate holding portion, to receive the processing liquid discharged from the nozzle;
a drainage mechanism to guide the acid chemical liquid discharged from the liquid receiving portion to a first drainage piping and to guide the alkaline chemical liquid discharged from the liquid receiving portion to a second drainage piping; and
a nozzle moving portion to move the nozzle between a processing position opposing the substrate held by the substrate holding portion and a standby position opposing the liquid receiving portion.

2. The substrate processing apparatus according to claim 1, further comprising:
a controlling portion to control supply of the plurality of types of processing liquids to the nozzle,
wherein when switching the type of the processing liquid to be discharged from the nozzle to the substrate, the controlling portion delays a supply stop timing of the processing liquid previously discharged from the nozzle, and simultaneously supplies the two types of processing liquids to the nozzle for a certain period of time.

3. The substrate processing apparatus according to claim 1 or 2, further comprising:
a storage portion to store a discharge order that is an order of discharging the plurality of types of processing liquids from the nozzle;
an input portion to be operated by a user to input the discharge order; and
a controlling portion to prohibit setting of the discharge order to discharge the alkaline chemical liquid after discharging the acid chemical liquid.

4. The substrate processing apparatus according to claim 1 or 2, further comprising:
a liquid tank into which the alkaline chemical liquid is to flow from the second drainage piping;
a supply piping to selectively supply the plurality of types of processing liquids to the nozzle;
a suck back mechanism, connected to the supply piping, to suck back the processing liquid staying between a connection point with the supply piping and a tip of the nozzle, and to allow the sucked processing liquid to flow to the liquid tank; and
a controlling portion to prohibit operation of the suck back mechanism when the processing liquid finally discharged from the nozzle in a discharge order that is an order of discharging the plurality of types of processing liquids from the nozzle to the substrate is a processing liquid other than the rinse liquid.

5. The substrate processing apparatus according to claim 1 or 2, further comprising:
a cup portion to receive the processing liquid discharged from the substrate,
wherein the drainage mechanism is to guide the acid chemical liquid discharged from the cup portion to the first drainage piping and to guide the alkaline chemical liquid discharged from the cup portion to the second drainage piping.

6. The substrate processing apparatus according to claim 1 or 2,
wherein the liquid receiving portion includes a first liquid receiving portion to receive the acid chemical liquid and a second liquid receiving portion to receive the alkaline chemical liquid, and
the drainage mechanism is to guide the acid chemical liquid discharged from the first liquid receiving portion to the first drainage piping, and guides the alkaline chemical liquid discharged from the second liquid receiving portion to the second drainage piping.

7. The substrate processing apparatus according to claim 1 or 2, further comprising:
a storage portion to store a discharge order that is an order of discharging the plurality of types of processing liquids from the nozzle to the substrate; and
a controlling portion to generate an order of discharging the plurality of types of processing liquids from the nozzle to the liquid receiving portion based on the discharge order.

8. The substrate processing apparatus according to claim 1 or 2,
wherein the plurality of types of processing liquids further include an organic solvent, and
the drainage mechanism is to guide the acid chemical liquid discharged from the liquid receiving portion to the first drainage piping, to guide the alkaline chemical liquid discharged from the liquid receiving portion to the second drainage piping, and to guide the organic solvent discharged from the liquid receiving portion to a third drainage piping.

9. The substrate processing apparatus according to claim 8, further comprising:
a cup portion to receive the processing liquid discharged from the substrate,
wherein the drainage mechanism is to guide the acid chemical liquid discharged from the cup portion to the first drainage piping, to guide the alkaline chemical liquid discharged from the cup portion to the second drainage piping, and to guide the organic solvent discharged from the cup portion to the third drainage piping.

10. The substrate processing apparatus according to claim 8,
wherein the liquid receiving portion includes a first liquid receiving portion to receive the acid chemical liquid, a second liquid receiving portion to receive the alkaline chemical liquid, and a third liquid receiving portion to receive the organic solvent, and
the drainage mechanism is to guide the acid chemical liquid discharged from the first liquid receiving portion to the first drainage piping, to guide the alkaline chemical liquid discharged from the second liquid receiving portion to the second drainage piping, and to guide the organic solvent discharged from the third liquid receiving portion to the third drainage piping.

11. A substrate processing method comprising:
a step of selectively discharging a plurality of types of processing liquids including an acid chemical liquid, an alkaline chemical liquid, and a rinse liquid from a nozzle located at a position opposing a liquid receiving portion located outside a substrate holding portion holding a substrate;
a step of guiding the acid chemical liquid discharged from the liquid receiving portion to a first drainage piping;
a step of guiding the alkaline chemical liquid discharged from the liquid receiving portion to a second drainage piping; and
a step of moving the nozzle to a position opposing the substrate to selectively discharge the plurality of types of processing liquids from the nozzle to the substrate.
